# EUROPEAN PATENT APPLICATION

(11) **EP 4 734 100 A1**
(43) Date of publication of application: **29.04.2026**
(21) Application number: 23943133.1
(22) Date of filing: 14.08.2023
(51) Int. Cl.: G09G 3/3266, G09G 3/3208, G09G 3/32

(54) **GATE DRIVING MODULE AND DISPLAY PANEL**

(30) Priority: 25.06.2023 CN 202310756734
(71) Applicant: Wuhan China Star Optoelectronics Semiconductor Display Technology Co., Ltd., Wuhan, Hubei 430079 (CN)
(72) Inventor: LIU, Yi, Wuhan, Hubei 430079 (CN); SUN, Feixiang, Wuhan, Hubei 430079 (CN)
(74) Representative: Zhu, Puxing
(86) International application number: PCT/CN2023/112836
(87) International publication number: WO 2025/000649

(57) **Abstract**

The present disclosure provides a gate driving module and a display panel, including a plurality of cascaded gate driving circuits, each of the gate driving circuits includes a stage transmission unit (outputting a current-stage stage transmission signal based on signals of the first node and the second node), an output unit (outputting a gate control signal based on the signal from the third node and the signal from one of the first node and the second node), a stage transmission frequency division control unit, and an output frequency division control unit. The stage transmission frequency division control unit controls a stage transmission output unit to output the current-stage stage transmission signal based on the signals from the third node and one of the first node and the second node. The output frequency division control unit controls the signal from the third node based on the frequency division control signal to control the output unit to output a current-stage gate control signal.

## Description

### TECHNICAL FIELD

The present disclosure relates to display technologies, and in particular to gate driving modules and display panels.

### BACKGROUND

Organic Light Emitting Diode (OLED) display panels are widely used due to their flexibility and other characteristics.

A gate driving circuit in OLED display panels generally outputs effective pulses step by step to sequentially activate multiple rows of sub pixels, and the refresh rate of the entire display area is the same, making it impossible to drive different areas with different refresh rates, resulting in limited usage scenarios.

Therefore, there are defects in the existing OLED display panels where different areas cannot achieve different refresh rates, and improvement is urgently needed.

### SUMMARY

The present disclosure provides a gate driving module and a display panel to achieve different refresh rates for driving different areas.

The present disclosure provides a gate driving module, including a frequency division signal line and a plurality of cascaded gate driving circuits. The frequency division signal line is configured to transmit a frequency division control signal to the plurality of the cascaded gate driving circuits. Each of the cascaded gate driving circuits includes a stage transmission unit, an output unit, a stage transmission frequency division control unit, and an output frequency division control unit.

The stage transmission unit includes a stage transmission receiving unit and a stage transmission output unit. The stage transmission receiving unit is configured to receive a stage transmission signal generated by an upper-stage gate driving circuit. The stage transmission output unit is electrically connected to the stage transmission receiving unit via a first node and a second node. The stage transmission output unit is configured to output a current-stage stage transmission signal to a lower-stage gate driving circuit based on signals from the first node and the second node.

The output unit is electrically connected to the stage transmission output unit via a third node and one of the first node and the second node, and is configured to output a gate control signal based on a signal from the one of the first node and the second node and a signal from the third node.

The stage transmission frequency division control unit is electrically connected to the stage transmission receiving unit via the first node or the second node. The stage transmission frequency division control unit is electrically connected to the stage transmission output unit via a fourth node. The stage transmission frequency division control unit is configured to control the signal from the one of the first node and the second node based on the frequency division control signal to control the stage transmission output unit to output the current-stage stage transmission signal.

The output frequency division control unit is connected between the third node and the one of the first node and the second node, and is configured to control the signal from the third node based on the frequency division control signal to control the output unit to output a current-stage gate control signal.

### BENEFICIAL EFFECTS

The present disclosure provides a gate driving module and a display panel, including the above frequency division signal line and the plurality of the cascaded gate driving circuits. The stage transmission frequency division control unit and the output frequency division control unit are disposed. The stage transmission frequency division control unit is electrically connected to the stage transmission receiving unit via the first node or the second node (further electrically connected the stage transmission output unit via the fourth node). The output frequency division control unit is connected between the third node and the one of the first node and the second node. The stage transmission frequency division control unit is configured to control the signal from the one of the first node and the second node based on the frequency division control signal to control the stage transmission output unit to output the current-stage stage transmission signal. The output frequency division control unit is configured to control the signal from the third node based on the frequency division control signal to control the output unit to output the current-stage gate control signal, so that the inefficiency of the gate control signal may not affect the inefficiency of the stage transmission signal. The sequential frequency decreasing modes of a plurality of areas of the display panel are capable of being achieved by setting whether the stage transmission signal has a stage transmission effective pulse. Any frequency conversion modes of the plurality of areas of the display panel is capable of being achieved by setting whether the gate control signal has a gate effective pulse (as the cascade effective pulse may always exist).

### DESCRIPTION OF THE DRAWINGS

To describe the technical solutions of the embodiments of the present disclosure more clearly, the following briefly introduces the accompanying drawings used in the description of the embodiments of the present disclosure. Apparently, the accompanying drawings described below illustrate only some exemplary embodiments of the present disclosure, and persons skilled in the art may derive other drawings from the drawings without making creative efforts.
FIG. 1 is a schematic structure diagram of a gate driving module provided by some embodiments of the present disclosure.
FIGS. 2 and 3 respectively are two circuit diagrams of a gate driving circuit provided by some embodiments of the present disclosure.
FIGS. 4 and 5 are schematic structural diagrams of a display panel provided by some embodiments of the present disclosure.
FIGS. 6 and 7 are circuit diagrams of a pixel driving circuit provided by some embodiments of the present disclosure.
FIGS. 8 and 9 are waveform diagrams of some signals in FIGS. 6 and 7, respectively.
FIG. 10 is a waveform diagram of some signals in a single-stage gate driving circuit provided by some embodiments of the present disclosure.
FIGS. 11 to 16 are waveform diagrams of some signals in a plurality of stages gate driving circuits provided by some embodiments of the present disclosure.
FIG. 17 is a waveform diagram of a data signal transmitted from a data line and two frequency division controls corresponding to two gate driving circuits.

### DETAILED DESCRIPTION

The technical solutions in the embodiments of the present disclosure will be described clearly and completely hereafter with reference to the accompanying drawings. Apparently, the described embodiments are only a part of but not all embodiments of the present disclosure. All other embodiments obtained by persons of ordinary skill in the art based on the embodiments of the present disclosure without creative efforts shall fall within the protection scope of the present disclosure.

In description of the disclosure, terms such as "first" and "second" are used herein for purposes of description, and should not be interpreted as indication or implication of relative importance, or implied indication of a number of the technical features. Therefore, features limited by terms such as "first" and "second" can explicitly or impliedly include one or more than one of these features. In the present disclosure, there is no distinction between a source and a drain of a transistor, and the two can be interchanged. Terms "low voltage" and "high voltage" refer to two voltages with relatively small voltage values and larger voltage values. They can represent two voltage values of the same signal at different times, or two voltage values of different signals at the same or different times. In addition, it should also be noted that the accompanying drawings only provide a structure that is closely related to the present disclosure, and some details that are not closely related to the application are omitted. The purpose is to simplify the accompanying drawings and make the invention points of the present disclosure clear at a glance, rather than indicating that the actual device is exactly the same as the accompany drawings, and does not serve as a limitation of the actual device.

Reference herein to "embodiment" means that a particular feature, structure, or characteristic described in connection with the embodiment may be included in at least one embodiment of the present disclosure. The appearances of the phrase at various places in the specification are not necessarily all referring to the same embodiment, nor are separate or alternative embodiments mutually exclusive of other embodiments. Those skilled in the art understand, both explicitly and implicitly, that the embodiments described herein may be combined with other embodiments.

The present disclosure provides a gate driving module, which includes but is not limited to the following embodiments and combinations of the following embodiments.

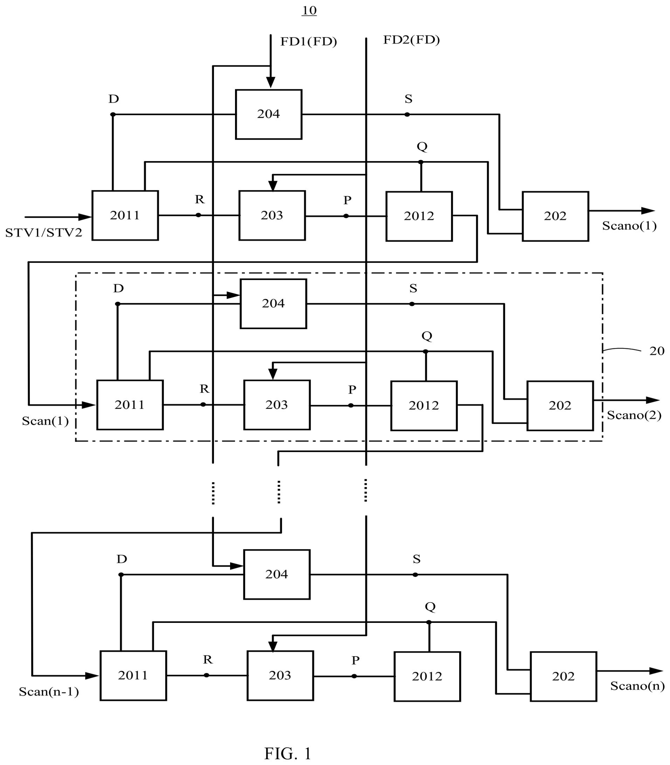

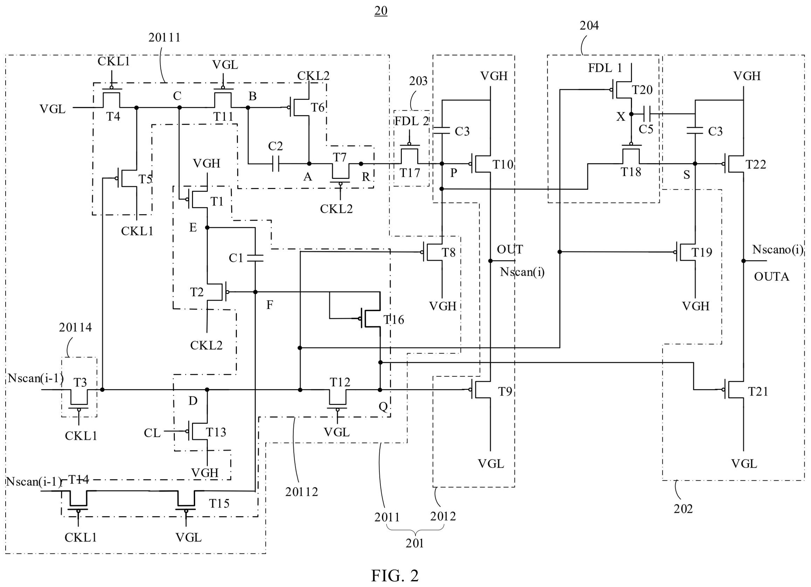

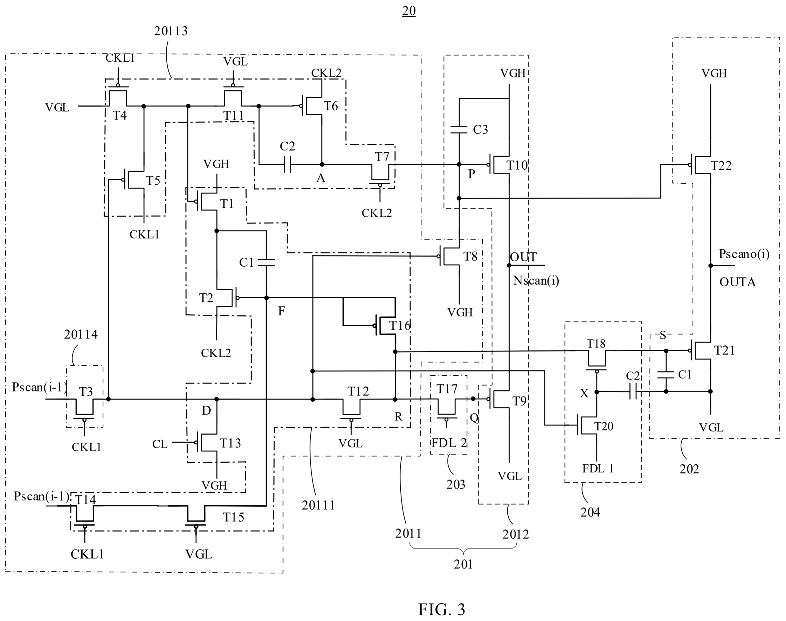

In one embodiment, as shown in FIG. 1, the gate driving module 10 includes a frequency division signal line FDL and a plurality of cascaded gate driving circuits 20, the frequency division signal line FDL is configured to is configured to transmit a frequency division control signal FD to the plurality of the cascaded gate driving circuits 20. As shown in FIGS. 2 and 3, the gate driving circuit 20 includes a stage transmission unit 201, an output unit 202, a stage transmission frequency division control unit 203, and an output frequency division control unit 204. The stage transmission unit 201 includes a stage transmission receiving unit 2011 and a stage transmission output unit 2012. The stage transmission receiving unit 2011 is configured to receive a stage transmission signal generated by an upper-stage gate driving circuit 20. The stage transmission output unit 2012 is electrically connected to the stage transmission receiving unit 2011 via a first node P and a second node Q, and is configured to output a current-stage stage transmission signal to a lower-stage gate driving circuit 20 based on signals of the first node P and the second node Q. The output unit 202 is configured to be electrically connected to the stage transmission output unit 2012 via a third node S and one of the first node P and the second nodes Q, and is configured to output a current-stage gate control signal based on a signal from the one of the first node P and the second node Q, and a signal from the third node S. The stage transmission frequency division control unit 203 is electrically connected to the stage transmission receiving unit 2011 via the first node P or the second node Q, and is electrically connected to the stage transmission output unit 2012 via a fourth node R. The stage transmission frequency division control unit 203 is configured to control the signal from one of the first node P and the second node Q based on the frequency division control signal FD to control the stage transmission output unit 2012 to output the current-stage stage transmission signal. The output frequency division control unit 204 is connected between the third node S and one of the first node P and the second node Q, and is configured to control the signal from the third node S based on the frequency division control signal FD to control the output unit 202 to output the current-stage gate control signal.

Specifically, taking n (n≥2) cascaded gate driving circuits 20 in FIG. 1 as an example for illustration, the first-stage gate driving circuit 2010 may convert a first startup signal STV1 or a second startup signal STV2 (the two phases are opposite) to be served as its corresponding "upper-stage gate control signal", and the current-stage gate control signal Scan(1) output based on this accordingly is transmitted to the lower-stage (second-stage) gate driving circuit 20. By analogy, the n-th stage gate driving circuit 20 may generate and output the current-stage (n-th stage) gate control signal Scan(n) based on the (n-1)-th stage gate control signal Scan(n-1). Taking the i-th stage gate driving circuit 20 in FIGS. 2 and 3 as an example for illustration, the i-th stage gate driving circuit 20 may generate and output the current-stage (i-th stage) gate control signal Scan(i) based on the (i-1)-th stage gate control signal Scan(i-1).

It can be understood that on the basis that the signal from one of the first node P and the second node Q electrically connected to the stage transmission output unit 2012 remains unchanged, on the one hand, there is the stage transmission frequency division control unit 203 connected between the stage transmission receiving unit 2011 and the stage transmission output unit 2012 in the embodiments, and the signal from the other one of the first node P and the second node Q may be controlled (whether it can be affected by the fourth node R) based on the frequency division control signal FD, so that the signal transmitted to the stage transmission output unit 2012 can be controlled, and then the specific case (whether there is a stage transmission effective pulse) of the stage transmission signal output from the current-stage stage transmission output unit 2012 can be determined, to determine whether it plays a driving role in the lower-stage gate driving circuit 20. If the stage transmission signal has effective stage-transmission pulses, it can be considered that the stage-transmission receiving unit 2011 in the lower-stage gate driving circuit 20 can work normally. In the same way, combined with the current-stage stage transmission frequency division control unit 203 to determine the specific case of the stage transmission signal output from the current-stage stage transmission output unit 2012. On the other hand, there are the output frequency division control unit 204 connected between the third node S and one of the first node P and the two nodes Q in the embodiments, and the signal from the third node S may be controlled based on the frequency division control signal FD, so that the specific case (whether there are gate effective pulses) of the current-stage gate control signal (that is, the signal transmitted to the corresponding multiple sub-pixels Pi in the display panel to control whether the sub-pixel Pi is turned on) output from the output unit 202 can be controlled, to determine whether to turn on the corresponding multiple sub-pixels Pi, if the gate control signal has gate effective pulses, it can be considered that the corresponding multiple sub-pixels Pi can be refreshed for later emission.

It should be understood that for the plurality of gate driving circuits 20 that are sequentially cascaded, if a plurality of gate control signals output from the first part of the plurality of gate driving circuits 20 output gate effective pulses once in one frame of every n1 frames, a plurality of gate control signals output from the second part of the plurality of gate driving circuits 20 output gate effective pulses once in one frame of every n2 frames, and a plurality of gate control signals output from the third part of the plurality of gate driving circuits 20 output gate effective pulses once in one frame of every n3 frames, it can be considered that three refresh rates of three display areas respectively composed of three parts of sub-pixels Pi that respectively correspond to the three parts of the gate driving circuits 20, respectively are (1/n1)*m, (1/n2)*m, (1/n3)*m, where m is the least common multiple of n1, n1 and n1.

In summary, in the embodiments, the gate control signal configured to determine the refresh rate of any display area of the display panel is directly determined by the corresponding output frequency division unit and the frequency division control signal FD at this time. An input terminal of the frequency division unit is connected to one of the first node P and the second node Q, and the other input terminal is connected to the third node S, where the third node S is connected to the first node P or the second node Q via the stage transmission frequency division unit, that is, it can be considered that the signal from the third node S is jointly determined by the stage transmission frequency division unit and the frequency division control signal FD loaded to the stage transmission frequency division unit, so the gate control signal is jointly determined by the stage transmission frequency division unit, the output frequency division unit, the frequency division control signal FD loaded to the stage transmission frequency division unit and the output frequency division unit. These three elements can be reasonably set to determine the refresh rate of the corresponding display area. Further, the above three elements in each of different gate driving circuits 20 corresponding to different display areas of the display panel can be reasonably set to achieve different refresh rates respectively.

In the embodiment, whether the stage transmission frequency division units in different gate driving circuits 20 are set differentially, whether the output frequency division units are set differentially, and whether the periods during which the frequency division control signal FD is effective respectively are set differentially, are not limited. In order to facilitate circuit design, the stage transmission frequency division unit and the output frequency division unit of the multi-stage gate driving circuit 20 may be set to the same value. Correspondingly, the time periods in which the frequency division control signal FD is effectively acted on the different gate driving circuits 20 respectively may be set differentially to achieve differentiated setting of refresh rates in different display areas.

In one embodiment, as shown in FIGS. 1 to 3, the frequency division control signal FD includes a first frequency division control signal FD1 and a second frequency division control signal FD2. The frequency division signal line FDL includes a first frequency division signal line FDL1 and a second frequency division signal line FDL2. The first frequency division signal line FDL1 is configured to transmit the first frequency division control signal FD1, and the second frequency division signal line FDL2 is configured to transmit the second frequency division control signal FD2. The first signal line FDL is electrically connected to the output frequency division control unit 204 to control the signal from the third node S. The second frequency division signal line FDL is electrically connected to the stage transmission frequency division control unit 203, to control the signal from one of the first node P and the second node Q.

It can be understood that in the embodiment, by specifically setting the frequency division signal line FDL as the independent first frequency division signal line FDL and the first frequency division signal line FDL, the first frequency division control signals FD1 and the second frequency division control signal FD2 (the two do not need to be the same) can be transmitted respectively and independently, to independently control the working status of the output frequency division control unit 204 and the stage transmission frequency division control unit 203, thereby respectively controlling the specific conditions of the stage transmission signal and gate signal generated from the current-stage gate driving circuit 20.

Specifically, the periods of effective action of the first frequency division control signal FD1 corresponding each stage of the gate driving circuit 20 and the periods of effective action of the second frequency division control signal FD1 corresponding each stage of the gate driving circuit 20 may be reasonably set to meet different cases. For each stage of the gate driving circuit 20, it may include but is not limited to the following cases: cases 1 to 4.

In case 1, the second frequency division control signal FD2 is reasonably set so that the signal from the fourth node R can act on the signal from the first node P or the signal from the second node Q, so that stage transmission signal generated and output from the stage transmission frequency division control unit 203 has stage transmission effective pulses, thereby controlling the stage transmission receiving unit 2011 in the lower-stage gate driving circuit 20 to operate normally.

Based on case 1, specific cases may include but are not limited to the following cases 1.1 to 1.2.

In case 1.1, the first frequency division control signal FD1 is reasonably set so that the gate control signal generated and output from the output frequency division unit has gate effective pulses, thereby controlling the corresponding multiple sub-pixels Pi to be turned on, that is, refreshing the corresponding multiple sub-pixels Pi for post-illumination;

In case 1.2, the first frequency division control signal FD1 is reasonably set so that the gate control signal generated and output from the output frequency division unit does not have a gate effective pulse, thereby controlling the corresponding multiple sub-pixels Pi not to be turned on, that is, not refreshing the corresponding multiple sub-pixels Pi for post-illumination.

Further, in case 1, if the periods of effective action of the second frequency division control signal FD2 corresponding to each stage of the gate driving circuit 20 is set that each stage of the stage transmission signal has a stage transmission effective pulse, that is, each stage of the stage transmission signal is uninterrupted, the first frequency division control signal FD1 may be set to control whether each stage of the gate control signals has a gate effective pulse. Combined with the above discussion, it can realize arbitrary frequency division of multiple display areas (the refresh rate of the latter display area may increase or decrease compared with the previous display area), that is, the relative several upper stages and the several lower stages of the gate control signals are respectively controlled to have or not have gate effective pulses in sequence, or, not have or have gate effective pulses in sequence.

In case 2, the second frequency division control signal FD2 is reasonably set so that the signal from the fourth node R cannot act on the signal from the first node P or the signal from the second node Q, so that the stage transmission signal generated and output from the stage transmission frequency division control unit 203 does not have stage transmission effective pulses (determined by the signal from the first node P or the signal from the second node Q), thereby controlling the stage transmission receiving unit 2011 of the lower-stage gate driving circuit 20 to not work normally. Meanwhile, since the signal from the third node S connected to the source of the output unit 202 is also determined by the signal from the first node P or the signal from the second node Q, it can also be considered that the signal from the third node S at this time may cause the current-stage gate control signal to have no gate effective pulses. Therefore, it can be considered that none from the current-stage to the final-stage gate control signals have gate effective pulses, and the corresponding multiple sub-pixels Pi all cannot be refreshed for post-illumination. Combined with the above discussion, it can only achieve frequency reduction of multiple display areas.

In case 3, the first frequency division control signal FD1 is reasonably set, so that the output frequency division control unit 204 may control the third node S to be acted upon by the first node P or the second node Q, so that the output unit 202 can be acted upon by the first node P or the second node Q.

Based on case 3, specific cases may include but are not limited to the following cases 3.1 to 3.2.

In case 3.1, the second frequency division control signal FD2 is reasonably set so that the signal from the fourth node R may act on the signal from the first node P or the signal from the second node Q, so that the stage transmission signal generated and output by the stage transmission frequency division control unit 203 may have stage transmission effective pulses, thereby controlling the stage transmission receiving unit 2011 of the lower-stage gate driving circuit 20 to work normally. Since the signal from the first node P or the signal from the second node Q may also act on the third node S to act on the output unit 202, therefore, at this time, the gate control signal generated and output from the output frequency division unit also has a gate effective pulse, thereby controlling the corresponding multiple sub-pixels Pi to turn on, that is, refreshing the corresponding multiple sub-pixels for post-illumination.

In case 3.2, the second frequency division control signal FD2 is reasonably set so that the signal from the fourth node R may act on the signal from the first node P or the signal from the second node Q, so that the stage transmission signal generated and output by the stage transmission frequency division control unit 203 does not have stage transmission effective pulses. Similar to "case 2", it shows that at this time, the signal from the first node P or the signal from the second node Q cannot invalidate the signal from the third node S, that is, it may also cause the current-stage gate control signal does not have gate effective pulses. Therefore, it can be considered that none from the current-stage to the final-stage gate control signals have gate effective pulses, and the corresponding multiple sub-pixels Pi all cannot be refreshed for post-illumination.

Further, in case 3, if the periods of effective action of the first frequency division control signal FD1 corresponding to each stage of the gate driving circuit 20 is set that each stage of the third nodes S is acted upon by the first node P or the second node Q, the second frequency division control signal FD2 may be set to control whether the signal from the fourth node R acts on the signal from the first node P or the signal from the second node Q, and whether the stage transmission signal generated and output from each stage of the stage transmission frequency division control units 203 has stage transmission effective pulses. Combined with the above discussion, it can realize the frequency reduction of the multiple display areas.

In case 4, the first frequency division control signal FDI is reasonably set so that the output frequency division control unit 204 cannot control the third node S to be acted upon by the first node P or the second node Q, and thus the output unit 202 cannot be acted upon by the first node P or the second node Q. That is, regardless of the signal from the first node P and the signal from the second node Q, the first frequency division control signal FD1 will act on the output frequency division control unit 204, so that the signal from the third node S may cause the current-stage gate control signal to have no gate effective pulses. Therefore, it can be considered that none from the current-stage to the final-stage gate control signals have gate effective pulses, and the corresponding multiple sub-pixels Pi all cannot be refreshed for post-illumination. Combined with the above discussion, it can only achieve frequency reduction of multiple display areas.

In one embodiment, as shown in FIGS. 1 to 3, the output frequency division control unit 204 includes a first frequency division transistor T18. The gate of the first frequency division transistor T18 is connected to the frequency division signal line FDL, and the source of the first frequency division transistor T18 is electrically connected to the first node P or the second node Q. The drain of the control transistor is electrically connected to the third three nodes S. The first frequency division control signal FD1 is configured to control the third node S to be electrically connected or disconnected from the first node P or the second node Q.

Combined with the above discussion, it can be seen that the first frequency division control signal FD1 may act on the output frequency division control unit 204 to control whether the third node S is acted upon by the first node P or the second node Q. Further, the embodiment illustrates that the first frequency division control signal FD1 may act on the gate of the first frequency division transistor T18 of the output frequency division control unit 204 to control the third node S be electrically connected or disconnected from the first node P or the second node Q.

Specifically, if it is electrically connected, it can be considered that the third node S can be acted upon by the first node P or the second node Q, equivalent to, the signal from the first node P or the second node Q may control whether the gate control signal generated and output from the output unit 202 has a gate effective pulse (i.e. case 3 above). If it is disconnected, it can be considered that the third node S cannot be acted upon by the first node P or the second node Q. Since the first node P or the second node Q configured to generate stage transmission signal cannot act on the output unit 202, it can be considered that the gate control signal generated and output from the output unit 202 has no gate effective pulse (i.e. case 4 above).

In one embodiment, as shown in FIGS. 1 to 3, the output frequency division control unit 204 further includes a second frequency division transistor T20. The gate of the second frequency division transistor T20 is electrically connected to the fifth node of the stage transmission unit 201. The source of the second frequency division transistor T20 is electrically connected to the first frequency division signal line FDL. The drain of the second frequency division transistor T20 is electrically connected to the gate of the first frequency division transistor T18. The first frequency division control signal FD1 and the signal from the fifth node are configured to control the third node S to be electrically connected or disconnected from the first node P or the second node Q. The signal from the fifth node is also configured to control the stage transmission signal and the gate control signal output from the current-stage gate driving circuit 20.

It can be understood that in the embodiment, the second frequency division transistor T20 electrically connected to the gate of the first frequency division transistor T18 is further provided, the turning on condition of the second frequency division transistor T20 is determined by the signal from the fifth node, and the signal from the fifth node is also configured to control the stage transmission signal and gate control signal output from the current-stage. That is, it can be considered that the signal state of the fifth node can feed back both the current-stage stage transmission signal and the current-stage gate control signal. So that the second frequency division transistor T20 can be controlled to turn on only when the state of the current-stage stage transmission signal and the current-stage gate control signal are appropriate, thereby causing the first frequency division control signal FD1 is transmitted to the gate of the current-stage first frequency division transistor T18 to control the turning on condition of the first frequency division transistor T18, which can take into account the correct waveform output from each stage of the stage transmission signal and the gate control signal to achieve differentiated settings of refresh rates in different display areas.

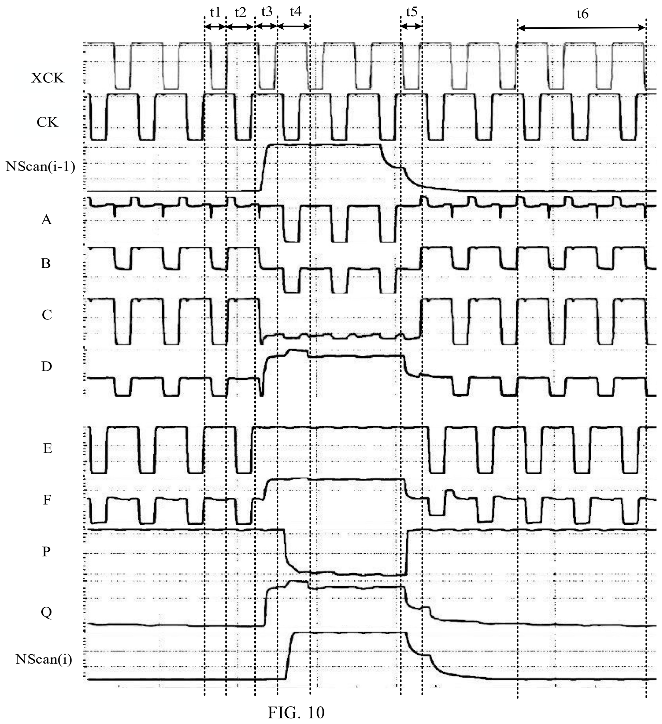

It should be noted that in the embodiment, the specific connection relationship between the fifth node and the above-mentioned module is not limited, just meet the above limitation "the signal from the fifth node is also configured to control the stage transmission signal and the gate control signal output from the current-stage gate driving circuit 20". For example, the fifth node may be electrically connected to the first node P or the second node Q, or even the fifth node may be the first node P or the second node Q. In the present disclosure, taking the fifth node being a node D as an example for explanation (based on the second frequency division transistor T20 in FIGS. 2 and 3 being respectively a P-type transistor and an N-type transistor, referring to the analysis of FIG. 10 below).

Specifically, combined with the following analysis of FIGS. 2 and 10, it can be seen that based on the current-stage stage transmission signal having stage transmission effective pulses (that is, the signal from the first node P and the signal from the second node Q are both effective signals), if the current-stage gate control signal needs to output a gate effective pulse, it can be considered that only when the signal from the fifth node can guarantee the voltage after the time node the time node (for example, the end point of the fifth stage t5 in FIG. 10) at which the current-stage gate effective pulse is completely output, can it be used to control the transmission of the first frequency division control signal FD1 to the gate of the current-stage first frequency division transistor T18. For example, the second frequency division transistor T20 is a P-type transistor, then it can be considered that the voltages of the five nodes are respectively higher voltage and lower voltage before and after the time node in which the current-stage gate effective pulse is completely output, so as to ensure that the second frequency division transistor T20 is turned on after the current-stage gate effective pulse is completely output.

In particular, if the current-stage gate control signal does not need to output a gate effective pulse, combined with the above discussion, it can be seen that the starting point (voltage jump) of the effective action period of the current-stage first frequency division control signal FD1 may be set before the time (such as the starting time of the third stage t3 in FIG. 10) when the signal from the fifth node corresponds to the voltage at which the current-stage gate effective pulse begins output, to ensure that the electrical connection between the third node S and the first node P or the second node Q is cut off before output of the current-stage gate effective pulse.

In one embodiment, as shown in FIGS. 1 to 3, the stage transmission frequency division control unit 203 includes a third frequency division transistor T17. The gate of the third frequency division transistor T17 is electrically connected to the second frequency division signal line FDL. The source of the first frequency division transistor T18 is electrically connected to the stage transmission receiving unit 2011 via the fourth node R. The drain of the third frequency division transistor T17 is electrically connected to the first node P or the second node Q. The second frequency division control signal FD2 is configured to control the fourth node R to be electrically connected or disconnected from the first node P or the second node Q.

Combined with the above discussion, it can be seen that the second frequency division control signal FD2 may act on the stage transmission frequency division control unit 203 to control whether the first node P or the second node Q is acted upon by the fourth node R. Further, the embodiment illustrates that the second frequency division control signal FD2 can act on the gate of the third frequency division transistor T17 of the stage transmission frequency division control unit 203 to control the fourth node R to be electrically connected or disconnected from the first node P or the second Node Q.

Specifically, if it is electrically connected, it can be considered that the first node P or the second node Q can be acted upon by the fourth node R, equivalent to, the signal from the fourth node R may control whether the stage transmission signal generated and output from the stage transmission output unit 2012 has a stage transmission effective pulse (i.e. case 1 above). If it is disconnected, it can be considered that the first node P or the second node Q cannot be acted upon by the fourth node R. Since the fourth node R configured to generate current-stage stage transmission signal cannot act on the stage transmission output unit 2012, it can be considered that the stage transmission signal generated and output from stage transmission output unit 2012 has no stage transmission effective pulse (i.e. case 2 above).

In one embodiment, as shown in FIGS. 2 and 3, the stage transmission output unit 2012 includes a first stage transmission output transistor T10 and a second stage transmission transistor T9. The gate of the first stage transmission output transistor T10 is electrically connected to the first node P. The source of the first stage transmission transistor T10 is electrically connected to the first voltage line to load the first voltage VGH. The drain of the first stage transmission transistor T10 is electrically connected to stage transmission output terminal OUT of the gate driving circuit 20 for outputting the stage transmission signal. The gate of the second stage transmission output transistor T9 is electrically connected to the second node Q. The source of the second stage transmission transistor T9 is electrically connected to the second voltage line to load the second voltage VGL. The drain of the second stage transmission transistor T9 is electrically connected to the stage transmission terminal OUT.

Specifically, the first node P may control the turning on condition of the first stage transmission output transistor T10 to control whether the first voltage can be transmitted to the stage transmission output terminal OUT. The second node Q can control the turning on condition of the second stage transmission output transistor to control whether the second voltage can be transmitted to the stage transmission output terminal OUT. As can be seen from the above discussion, in the present disclosure, a third frequency division transistor T17 connected between the fourth node R and the first node P or the second node Q is provided to control whether the first node P or the second node Q can receive the signal from the fourth node R, to control the turning on condition of the first output transistor T22 or the second output transistor T21, thereby controlling the specific conditions of the stage transmission signal generated and output from the stage transmission output terminal OUT.

For example, when the first stage transmission transistor T10 is turned on and the second stage transmission transistor T9 is turned off, the gate control signal may be equal to the first voltage. For example, the first stage transmission transistor T10 is turned off and the second stage transmission transistor T9 is turned on, the generated stage transmission signal may be equal to the second voltage, for another example, when both are turned off, the generated transmission signal may be equal to the previous voltage. For another example, when both are turned on, the generated transmission signal may range between the first voltage and the second voltage.

In one embodiment, as shown in FIGS. 2 and 3, the output unit 202 includes a first output transistor T22 and a second output transistor T21. The gate of the first output transistor T22 is electrically connected to the third node S. The source of the first output transistor T22 is electrically connected to the first voltage line. The drain of the first output transistor T22 is electrically connected to the gate output terminal OUTA of the gate driving circuit 20 for outputting the gate control signal. The gate of the second output transistor T21 is electrically connected to the first node P or the second node Q. The source of the second output transistor T21 is electrically connected to the second voltage line. The drain of the second output transistor T21 is electrically connected to the gate output terminal OUTA.

In the same way as discussed above, the third node S may control the turning on condition of the first output transistor T22 to control whether the first voltage can be transmitted to the gate output terminal OUTA. The first node P or the second node Q can control the turning on condition of the second output transistor T21 to control whether the second voltage can be transmitted to the gate output terminal OUTA. Combined with the above discussion, it can be seen in the present disclosure that the first frequency division transistor T18 connected between the third node S and the first node P or the second node Q is provided to control whether the third node S can receive the signal from the first node P or the second node Q, to control the turning on condition of the first output transistor T22 or the second output transistor T21, thereby controlling the specific conditions of the gate control signal generated and output from the gate output terminal OUTA.

In one embodiment, the gate driving circuit 20 is electrically connected to at least one corresponding pixel driving circuit 302. The gate output terminal OUTA is electrically connected to a pixel transistor of each corresponding pixel driving circuit 302, and the first voltage is greater than the second voltage. As shown in FIG. 2, the pixel transistor is an N-type transistor. The drain of the third frequency division transistor T17 and the sources of the first frequency division control transistor are all electrically connected to the first node P (at this time, it can be considered that the gate driving circuit 20 is the i-th stage NScan circuit, the generated gate control signal is the NScano(i) signal, the stage transmission signal is the NScan(i) signal, and the upper-stage transmission signal is the NScan(i-1) signal). Or as shown in FIG. 3, the pixel transistor is a P-type transistor, and the drain of the third frequency division transistor T17 and the source of the first frequency division control transistor are both electrically connected to the second node Q (at this time, it can be considered that the gate driving circuit 20 is the i-th stage PScan circuit, the generated gate control signal is the PScano(i) signal, and the stage transmission signal is the PScan(i) signals, and the upper-stage transmission signal is the PScan(i-1) signal).

In the embodiment, the architecture of the pixel driving circuit 302 is not limited. It can be considered that the pixel transistor may control turning on condition of the corresponding sub-pixel Pi under the control of the gate control signal output from the gate driving circuit 20. Specifically, in the embodiment, based on the fact that the first voltage is greater than the second voltage, when the pixel transistor is the N-type transistor, the drain of the third frequency division transistor T17 and the source of the first frequency division control transistor are electrically connected to the first node P, so that the turning on condition of the first stage transmission transistor T10 and the first output transistor T22 can be controlled, to control whether the larger first voltage (which can be the effective voltage of the N-type transistor) can be transmitted to N-type pixel transistor to control whether the corresponding sub-pixel Pi is turned on. When the pixel transistor is the P-type transistor, the drain of the third frequency division transistor T17 and the source of the first frequency division control transistor are electrically connected to the second nodes Q, so that the turning on condition of the second stage transmission output transistor T9 and the second output transistor T21 can be controlled to control whether the smaller second voltage (which can be the effective voltage of the P-type transistor) can be transmitted to the gate of the P-type pixel transistor to control whether the corresponding sub-pixel Pi is turned on.

Based on the above discussion, if the durations of the effective voltage required for the N-type and P-type pixel transistor to be turned on are equal, it can be considered that in the NScano signal output from the NScan circuit and PScano signal output from the PScan circuit, the voltage value (such as but not limited to being equal to the first voltage) of the gate effective pulse of the former is greater than the voltage value (such as but not limited to being equal to the second voltage) of the gate effective pulse of the latter, and the pulse widths of the gate effective pulses of both may be equal.

Further, since the stage transmission receiving unit 2011 can receive the upper-stage stage transmission signal and based on the stage transmission function of the stage transmission signal, it can be seen that the startup signal STV1 loaded into the first-stage NScan circuit can be obtained by translating the stage transmission signal NScan (1) generated by the first-stage gate driving circuit 20 along the negative direction of the time axis, and the startup signal STV2 loaded into the first-stage PScan circuit can be obtained by translating the stage transmission signal PScan (1) generated by the first-stage gate driving circuit 20 along the negative direction of the time axis by the same distance. The voltage values of the stage transmission effective pulses of the two can be equal to the first voltage and the second voltage, respectively. The first startup signal STV1, the second startup signal STV2, the NScano signal, the PScano signal, the NScan signal, and the PScan signal can all be periodic signals.

In one embodiment, as shown in FIGS. 2 and 3, the stage transmission receiving unit 2011 includes a fourth node control unit 20111, a second node control unit 20112 (as shown in FIG. 2) or the first node control unit 20113 (as shown in FIG. 3), and an input unit 20114. The fourth node control unit 20111 is electrically connected to a clock signal line and the fourth node R. The fourth node control unit 20111 is configured to control the signal from the fourth node R based on the clock signal transmitted from the clock signal line. The clock signal line includes but not limited to a first clock signal line CKL1 and a second clock signal line CKL2. The first clock signal XCK and the second clock signal line CKL2CK respectively loaded by the two can be symmetrical about the time axis. There is no limit on the voltage value at the intersection of the time axis and the voltage axis, and both can include different voltage values. The second node control unit 20112 is electrically connected to the clock signal line and the second node Q for controlling the signal from the second node Q based on the clock signal. The first node control unit 20113 is electrically connected to the clock signal line and the first node P, and is configured to control the signal from the first node based on the clock signal. The input terminal of the input unit 20114 is electrically connected to the upper-stage gate driving circuit 20 to load the stage transmission signal generated by the upper-stage gate driving circuit 20. The output terminal of the input unit 20114 is electrically connected to the fourth node control unit 20111 and the second node control unit 20112, or electrically connected to the fourth node control unit 20111 and the first node control unit 20113.

It should be noted that in the present disclosure, for the convenience of description, in the schematic diagram, only taking the second stage transmission transistor T9 located below the first stage transmission transistor T10 (that is, the second node Q is located below the first node P) as an example for explanation. Similarly, the second output transistor T21 may also be located below the first output transistor T22 as an example. In fact, what the present disclosure protects is the connection relationship of multiple electronic devices and is not limited to the positional relationship. Based on the stage transmission signal loaded by the input unit 20114 and generated by the upper-stage driving circuit 20, as shown in FIG. 2, for the NScan circuit, since the stage transmission frequency division control unit 203 is connected to the first node P located close to the top, that is, it can be considered that the fourth node R is also disposed close to the top. It can be considered that the fourth node control unit 20111 needs to be disposed close to the top to control the voltage of the fourth node R (further combined with the stage transmission frequency division control unit 203 to control the voltage of the first node P). The voltage of the second node Q needs to be controlled by the second node control unit 20112 disposed close to the bottom. As shown in FIG. 3, for the PScan circuit, since the stage transmission frequency division control unit 203 is connected to the second node Q located close to the bottom, that is it can be considered that the fourth node R is also disposed close to the bottom. It can be considered that the fourth node control unit 20111 needs to be disposed close to the bottom to control the voltage of the fourth node R (further combined with the stage transmission frequency division control unit 203 to control the second node Q), and the voltage of the first node P needs to be controlled by the first node control unit 20113 disposed close to the top.

In one embodiment, as shown in FIG. 2, the stage transmission frequency division control unit 203 and the output frequency division control unit 204 are both electrically connected to the first node P (that is, taking the gate driving circuit 20 being the NScan circuit as an example for explanation). The input unit 20114 includes an input transistor T3. The gate of the input transistor T3 loads the clock signal (such as connecting the first clock signal line CKL1 to load the first clock signal). The source of the input transistor T3 is configured as the input terminal of the input unit 20114, and the drain of the input transistor T3 is configured as the output terminal of the input unit 20114. The fourth node control unit 20111 includes a first transistor T4, a second transistor T6 and a third transistor T7 arranged in series, and a seventh transistor T5. The gate of the seventh transistor T5 is electrically connected to the drain of the input transistor T3. The source of source of T5 is loaded with the clock signal (such as the first clock signal). The gate of the first transistor T4 is loaded with the clock signal (such as the first clock signal). The source of the first transistor T4 is loaded with the second voltage. The drain of the first transistor T4 is electrically connected to the gate of the second transistor T6 and the drain of the seventh transistor T5. The drain of the second transistor T6 is electrically connected to the source of the third transistor T7. The source of the second transistor T6 and the gate of the third transistor T7 are both loaded with the clock signal. The drain of the third transistor T7 is electrically connected to the fourth node R. The second node control unit 20112 includes a fourth transistor T13, a fifth transistor T1 and a sixth transistor T2 arranged in series, and a first capacitor C1. The gate (electrically connected to the control line CL) of the fourth transistor T13 is loaded with the control signal, the source of the fourth transistor T13 is loaded with the first voltage, and the drain of the fourth transistor T13 is electrically connected to the second node Q. The gate of the fifth transistor T1 is electrically connected to the drain of the first transistor T4, the source of the fifth transistor T1 is loaded with the first voltage, and the drain of the fifth transistor T1 is electrically connected to the drain of the sixth transistor T2. The drain of the sixth transistor T2 is loaded with the clock signal, and the gate of the sixth transistor T2 is also loaded with the stage transmission signal generated by the upper-stage gate driving circuit 20. The first capacitor C1 is electrically connected between the gate and the drain of the sixth transistor T2.

In the present disclosure, taking the transistors of the gate driving circuit 20 being all P-type transistors as an example, and explaining the working principle of some signals in some states: when starting up, the control signal transmitted by CL can control the fourth transistor T13 to turn on to transmit the first voltage to the second node Q. later, when the low voltage in the first clock signal and the low voltage in the (i-1)-th stage gate control signal NScano(i-1) are presented, the gate control signal NScano(i-1) controls both the seventh transistor T5 and the second output transistor T21 to turn on. The second voltage is transmitted to the stage transmission output terminal OUT via the second output transistor T21, and the first clock signal controls the first transistor T4 turn on. The second voltage is transmitted to the gate of the second transistor T6 to control the second transistor T6 to turn on. At this time, the high voltage of the second clock signal controls the third transistor T7 to turn off. later, when the high voltage in the first clock signal is present, the input transistor T3, the second transistor T6 and the first transistor T4 are turned off. At this time, it can be considered that the second output transistor T21 remains on, the low voltage of the second clock signal controls the third transistor T7 to turn on, and the fourth node R is still not loaded with voltage. The stage transmission output terminal OUT still outputs the second voltage.

It should be noted that the present disclosure does not limit the type of each transistor of the gate driving circuit 20. For example, they may all be P-type transistors, or some may be N-type transistors and the other part may be P-type transistors. Corresponding signal may also be matched and set based on the type of the transistor. For details, please refer to the principle description of "the transistors of the gate driving circuit 20 are all P-type transistors" in the full text.

Further, the fourth node control unit 20111 may further include an eighth transistor T11 and a second capacitor C2. The second node control unit 20112 may further include a ninth transistor T12. The stage transmission output unit 2012 may further include a third capacitor C3 electrically connected between the gate and the source of the first output transistor T22. The gate of the eighth transistor T11 and the gate of the ninth transistor T12 may all be loaded with a second voltage to remain on. The source and drain of the eighth transistor T11 are electrically connected to the drain of the first transistor T4 and the gate of the second transistor T6 respectively. The second capacitor C2 is electrically connected between the gate and the drain of the second transistor T6. The source and drain of the ninth transistor T12 are electrically connected to the drain of the input transistor T3 and the second node Q respectively.

The first capacitor C1, the second capacitor C2 and the third capacitor C3 may be configured to maintain the voltage of the corresponding node and play a coupling role. The eighth transistor T11 and the ninth transistor T12 may respectively ensure that are turned on only when the voltage of the sources of the first output transistor T22 and the second output transistor T21 are low enough, to maintain a lower voltage of their drain. It is beneficial for the turning on of both the first output transistor T22 and the second output transistor T21, respectively.

In one embodiment, as shown in FIG. 2, the second node control unit 20112 further includes a tenth transistor T14 and an eleventh transistor T16. The source of the tenth transistor T14 is loaded with the stage transmission signal generated by the upper-stage gate driving circuit 20. The gate of the tenth transistor T14 is loaded with the clock signal (the first clock signal). The drain of the tenth transistor T14 is electrically connected to the gate of the sixth transistor T2. The gate and source of the eleventh transistor T16 are both electrically connected to the gate of the sixth transistor T2. The drain of the eleventh transistor T16 is electrically connected to the second node Q. In the same way, a twelfth transistor T15 may further be provided to maintain the gate of the sixth transistor T2 with a lower voltage. The gate of the twelfth transistor T15 may be loaded with a second voltage. The source and the drain of the twelfth transistor T15 may be electrically connected to the drain of the tenth transistor T14 and the gate of the sixth transistor T2 respectively.

It can be understood that in the embodiment, the second node control unit 20112 is further provided with the above-mentioned tenth transistor T14 and the eleventh transistor T16. The tenth transistor T14 may be configured to control the voltage of the gate of the sixth transistor T2. The eleventh transistor T16 connected between the second node Q and the gate of the sixth transistor T2 is further provided, so that the second node Q is not directly electrically connected to the first capacitor C1 to avoid being affected by the coupling effect of the first capacitor, maintaining the lower voltage of the second node Q.

It should be noted that, comparing FIG. 3 with FIG. 2, it can be seen that one of the differences between the PScan circuit and the NScan circuit is the difference between the second startup signal STV2 and the first startup signal STV1 as discussed above. The specific structures of the input unit 20114 and the output unit 202 of the two may be the same. Another difference is that the NScan circuit needs to include the fourth node control unit 20111 and the second node control unit 20112, while the PScan circuit needs to include the fourth node control unit 20111 and the first node control unit 20113. The specific structure of the fourth node control unit 20111 of the NScan circuit may be the same as that of the first node control unit 20113 of the PScan circuit. The difference is that the output terminal of the former is connected to the first node P via the stage transmission frequency division control unit 203, and the output terminal of the latter is directly connected to the first node P. Similarly, the specific structure of the second node control unit 20112 of the NScan circuit may be the same as that of the third node control unit of the PScan circuit. The difference is that the output terminal of the former is directly connected to the second node Q, while the output terminal of the latter is connected to the second node Q via the stage transmission frequency division control unit 203.

Further, the gate driving circuit 20 in the present disclosure may be, but is not limited to, an EM circuit. The difference between the EM circuit and the NScan circuit is that the first startup signal STV1 is replaced by the third startup signal STV3. The signal STV3 can be understood as translating the first startup signal STV1 by a certain distance along the negative direction or the positive direction of the time axis, and the waveforms of the two do not overlap. Similarly, the third startup signal STV3 can also be a periodic signal.

The present disclosure provides a display panel, which includes but is not limited to the following embodiments and combinations of the following embodiments.

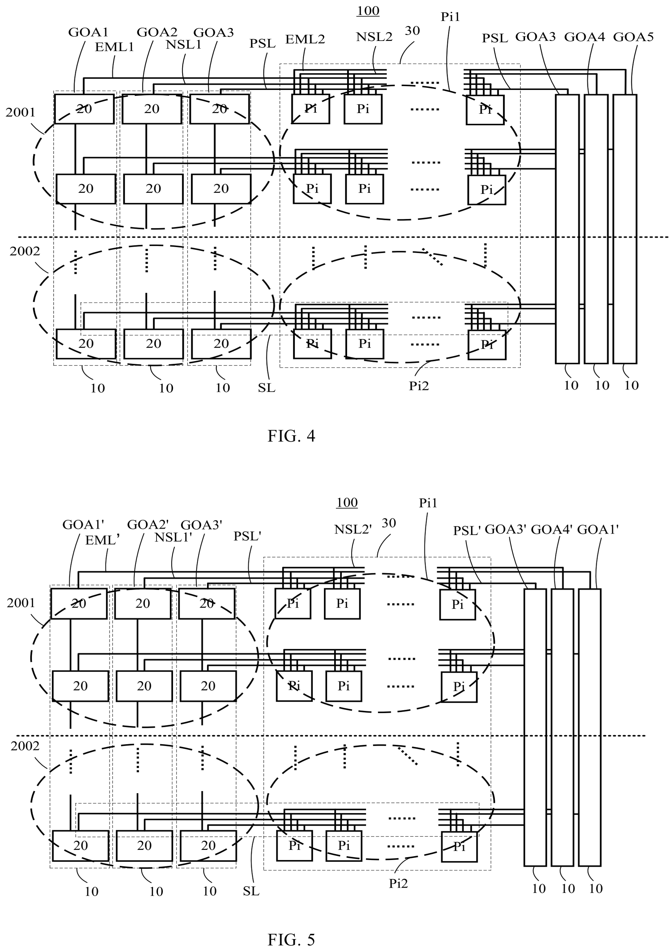

In one embodiment, as shown in FIGS. 4 to 7, the display panel 100 includes the gate driving module 10 as described in any of the above and a panel body 30. The panel body 30 includes a plurality of sub-pixels Pi and a plurality of scan lines SL. The plurality of sub-pixels Pi include a plurality of light-emitting devices 301 and a plurality of pixel driving circuits 302 for driving the light-emitting devices 301 to emit light. The pixel driving circuits includes at least one transistor (i.e. the pixel transistor discussed above). The gate control signal output from the gate driving circuit 20 is transmitted to the gates of the transistors of the corresponding plurality of pixel driving circuits 302 via the corresponding scanning lines.

In FIG. 4, taking the display panel 100 including six gate driving modules 10 as an example to illustrate. The six gate driving modules 10 include a GOA1, a GOA2, two GOA3, a GOA4, and aGOA5, which are electrically connected to the corresponding sub-pixel Pi via the first scan line EML1, the second scan line NSL1, the third scan line, the fourth scan line NSL2, and the fifth scan line EML2 respectively. For example, the two GOA3 may be but are not limited to the same PScan circuit, that is, the signals (the second startup signal STV2) loaded by the two and the signals output from the two may be the same respectively to improve the reliability of the PScan signals output from the two. For example, the GOA1 and the GOA5 may be two different EM circuits, for example, the corresponding third startup signals STV3 of the two may be different (such as, but not limited to, the value of at least one of the effective pulse widths and the starting times of the two may be different). For example, the GOA2 and the GOA4 may be two different NScan circuits respectively. For example, the corresponding first startup signals STV1 of the two may be different (such as, but not limited to, the value of at least one of the effective pulse widths and the starting times of the two may be different).

The difference between FIG. 5 and FIG. 4 is that the six gate driving modules 10 include two GOA1', aGOA2', two GOA3', and a GOA4', which are electrically connected to the corresponding sub-pixels Pi via the sixth scan line EML' the seventh scan line NSL1', the eighth scan line PSL1', and the ninth scan line NSL2' respectively. Similarly, the two GOA1' may be but are not limited to the same EM circuit. The GOA2' and the GOA4' may be two different NScan circuits. For example, the two first startup signals STV1 corresponding to the two may be different, and the two GOA3 may be but are not limited to the same PScan circuit.

It should be noted that FIG. 4 and FIG. 5 only illustrate the connection relationship between multiple gate driving circuits 20 of the same gate module and the connection relationship between each one and multiple sub-pixels Pi. As for the signal lines connected to each gate driving circuit 20, please refer to FIGS. 1 to 3 and the above related text descriptions.

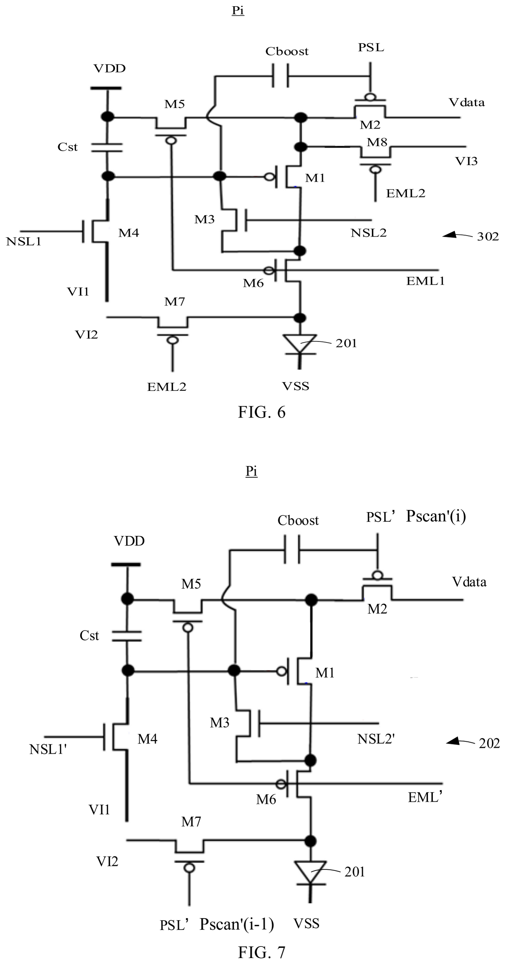

Specifically, as shown in FIG. 4 and FIG. 6, FIG. 6 includes a pixel driving circuit 302 corresponding to the arrangement of the gate driving module 10 in FIG. 4. The pixel driving circuit 302 may include a data transistor M2. The source of the transistor M2 is loaded with the data signal Vdata, the drain of the data transistor is electrically connected to the source of the driving transistor M1, and the gate of the data transistor M2 (such as the P-type transistor) may be electrically connected to the third scan line PSL to load PScan signal.

The pixel driving circuit 302 may further include a restoration transistor M4 and a compensation transistor M3. The gate of the restoration transistor M4 (such as an N-type transistor) may be electrically connected to the scan line NSL1 to load the NScan1 signal. The restoration transistor M4 is configured to transmit the reset signal VI1 to the gate of the driving transistor M1 for restoration. The gate of the compensation transistor M3 (such as an N-type transistor) may be electrically connected to the fourth scan line NSL2 to load the NScan2 signal. The source and the drain of the compensation transistor M3 are electrically connected to the drain and the gate of the driving transistor M1 respectively.

The pixel driving circuit 302 may further include an initialization transistor M7. The gate of the initialization transistor M7 (such as a P-type transistor) is electrically connected to the fifth scan line EML2 to load the EM2 signal. The drain of the initialization transistor M7 is electrically connected to a terminal of the light-emitting device 301 (the other terminal of the light-emitting device 301 may be loaded with a low voltage signal VSS). The initialization transistor M7 is configured to transmit the initialization signal VI2 to the terminal of the light-emitting device 301 for initialization.

The pixel driving circuit 302 further includes a reset transistor M8. The gate of the reset transistor M8 (such as a P-type transistor) may be electrically connected to the fifth scan line EML2 to load the EM2 signal. The drain of the reset transistor M8 is electrically connected to the source of the driving transistor M1, and the reset transistor M8 is configured to transmit the reset signal VI3 to the source of the driving transistor M1 to reset its voltage.

The pixel driving circuit 302 may further include a first light-emitting control transistor M5 and a second light-emitting control transistor M6. The source of the first light-emitting control transistor M5 is loaded with the first high voltage VDD. The drain of the first light-emitting control transistor M5 is electrically connected to the drain of the driving transistor M1. The source and the drain of the second light-emitting control transistor M6 are electrically connected to the drain of the driving transistor M1 and one terminal of the light-emitting device 301 respectively. The gates of the first light-emitting control transistor M5 and the second light-emitting control transistor M6 (for example, both are P-type transistors) are electrically connected to the first scan line EML1 to load the EM1 signal, and both are configured to control the light-emitting time of the light-emitting device 301 based on the EM1 signal.

The pixel driving circuit 302 further includes a storage capacitor Cst, which is connected in series between the source of the first light-emitting control transistor M5 and the gate of the driving transistor M1.

The pixel driving circuit 302 further includes a boost capacitor Cboost, and the boost capacitor Cboost is connected in series between the gate of the driving transistor M1 and the gate of the data transistor M2.

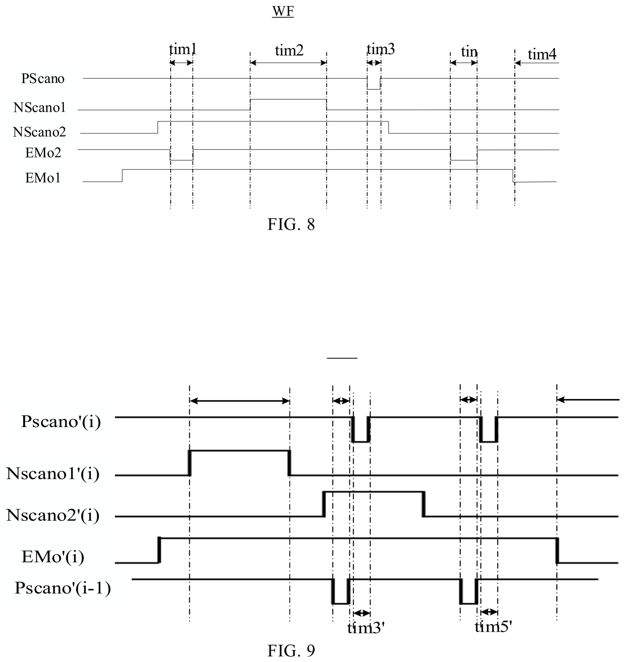

Based on the above discussion, as shown in FIG. 8, which is a timing diagram corresponding to the pixel driving circuit 302 in FIG. 7, a write frame WF of the display panel may include a first restoration phase tim1, a second restoration phase tim2, a data writing stage tim3 and a lighting phase tim4, the specific working process is as follows.

In the first restoration phase tim1, the initialization transistor M7 and the reset transistor M8 are turned on based on the corresponding EMo2 signal, and the compensation transistor M3 is turned on based on the corresponding NScano2 signal, so that the anode of the light-emitting device 301 may be reset based on the initialization signal V12. The input terminal, the output terminal and the control terminal source (the source, the drain and the gate) of the driving transistor M1 are reset based on the reset signal VI3.

In the second restoration phase tim2, the restoration transistor M4 is turned on based on the corresponding NScano1 signal, and the compensation transistor M3 is turned on based on the corresponding NScano2 signal, so that the gate and the drain of the driving transistor M1 may be reset based on the initialization signal VI2.

In the data writing phase tim3, the data transistor M2 is turned on based on the corresponding PScano signal, and the compensation transistor M3 is turned on based on the corresponding NScano2 signal, so that the gate of the driving transistor M1 may write the data signal Vdata.

In the light-emitting phase tim4, the first light-emitting control transistor M5 and the second light-emitting control transistor M6 are turned on based on the EMo1 signal, so that the driving transistor M1 generates a driving current to drive the corresponding light-emitting device 301 to emit light.

Further, between the light-emitting phase tim4 and the data writing phase tim3, a third restoration phase tin may further be provided. In the third restoration phase tin, the initialization transistor M7 and the reset transistor M8 are turned on based on the corresponding EMo2 signal, so that the anode of the light-emitting device 301 is reset based on the initialization signal VI2, and the source and drain of the driving transistor M1 are reset based on the reset signal VI3.

It should be noted that, as can be seen from the difference in the settings of the gate driving module 10 in FIG. 5 and FIG. 4, combined with FIG. 5 and FIG. 7, FIG. 7 includes the pixel driving circuit 302 corresponding to the settings of the gate driving module 10 of FIG. 5. That is, the pixel driving circuits 302 in FIG. 7 is only driven by the same EM circuit, so it can only be electrically connected to the same sixth scan line EML' and are loaded with the same signal (but cannot be electrically connected to the first scan line EML1 and the fifth scan line EML2 and are loaded with two different signals as in FIG. 6).

Specifically, as shown in FIG. 7, compared to FIG. 6, the difference is that the reset transistor M8 is removed, the first scan line EML1 is replaced by the sixth scan line EML', and the second scan line NSL1 is replaced by the seventh scan line NSL1', the third scan line PSL is replaced by the eighth scan line PSL1', the fourth scan line NSL2 is replaced by the ninth scan line NSL2', and the fifth scan line EML2 is also replaced by the upper-stage eighth scan line PSL1'.

Based on the above discussion, as shown in FIG. 9, which is a timing diagram corresponding to the pixel driving circuit 302 in FIG. 7, the writing frame WF of the display panel may include a first restoration phase tim1', a second restoration phase tim2', a data writing phase tim3' and a light-emitting phase tim4', taking the i-th stage gate driving circuit 20 as an example, the specific working process is as follows.

In the first restoration phase tim1', the restoration transistor M4 is turned on based on the corresponding NScano1'(i) signal, so that the gate of the driving transistor M1 is reset based on the initialization signal VI1;

In the second restoration phase tim2', the initialization transistor M7 is turned on based on the corresponding PScanol'(i-1) signal, so that the anode of the light-emitting device 301 can be reset based on the initialization signal VI2, and the compensation transistor M3 is turned on based on the corresponding NScanol'(2) signal.

In the data writing phase tim3', the data transistor M2 is turned on based on the corresponding PScanol'(i) signal, and the compensation transistor M3 is turned on based on the corresponding NScano2'(i) signal, so that the gate of the driving transistor M1 can write data signal Vdata.

In the third restoration phase tim4', the initialization transistor M7 is turned on based on the corresponding PScanol'(i-1) signal, so that the anode of the light-emitting device 301 can be reset again based on the initialization signal V12.

In the coupling phase tim5', the data transistor M2 is turned on based on the corresponding PScanol'(i) signal. At this time, regardless of the data signal Vdata, since the compensation transistor M3 is turned off, it will not affect the gate voltage of the driving transistor M1. But Since the gate voltage of the data transistor M2 decreases, the gate voltage of the driving transistor M1 also increases.

In the light-emitting phase tim6', the first light-emitting control transistor M5 and the second light-emitting control transistor M6 are turned on based on the EMo'(i) signal, so that the driving transistor M1 generates a driving current to drive the corresponding light-emitting device 301 to emit light. Since the gate voltage of the driving transistor rises to a value M1 in the coupling phase tim5' greater than the data voltage given by the data signal Vdata in the data writing stage tim3', the light-emitting device 301 will have greater brightness, and it can also be considered that it can effectively reduce the upper limit of the data voltage and save power consumption.

Based on the above analysis, it can be seen that in the writing frame WF, it is necessary to achieve normal light emission of each row of sub-pixels Pi, that is, each stage of the gate driving circuits 20 (each of GOA1 to GOA5 and each of GOA1' to GOA4') needs to output the corresponding gate effective pulse in the corresponding time period to control the corresponding transistor of the pixel driving circuit 302 to realize the corresponding function to turn on the sub-pixel Pi. It can also be considered that if the gate driving circuit 20 is unable to output the corresponding gate effective pulse in the corresponding time period, the corresponding row of the sub-pixels Pi will not be able to emit light.

As shown in FIG. 6 and FIG. 7, if the PScano signal and PScanol'(i) signal do not have a gate effective pulse (low voltage), the data transistor M2 cannot be turned on, which may cause the data signal to be unable to be written to the source of the driving transistor M1, and the sub-pixel Pi will not be able to turn on. If the EM1 signal and the EMo'(i) signal do not have a gate effective pulse (low voltage), the first light-emitting control transistor M5 and the second light-emitting control transistor M6 will not be able to turn on, resulting in the driving current cannot be formed and the sub-pixel Pi cannot be turned on. If the NScano2 signal and the NScano2'(i) signal do not have a gate effective pulse (high voltage), the compensation transistor M3 cannot be turned on, resulting in the data signal being unable to be written to the gate of the driving transistor M1, and the sub-pixel Pi will not be able to turn on. Of course, if the EMo2 signal, NScano1 signal, and NScano1'(i) signal do not have effective pulses, they will also have a certain impact on the light emission of the sub-pixel Pi.

Specifically, based on the pixel driving circuit 302 shown in FIG. 6, at least one of the three gate driving circuits 20 configured to respectively generate PScano signals, EMo1 signals, or NScano2 signals in the present disclosure may be provided with the stage transmission frequency division control unit 203 and the output frequency division control unit 204 discussed in the above article. Based on the pixel driving circuit 302 shown in FIG. 7. at least one of the three gate driving circuits 20 configured to respectively generate PScanol'(i) signals, EMo'(i) signals, or NScano2'(i) signals in the present disclosure may be provided with the stage transmission frequency division control unit 203 and the output frequency division control unit 204 discussed in the above article. In this way, based on the premise that the startup signal (such as the first startup signal STV1, the second startup signal STV2, or the third startup signal STV3) of the first-stage gate driving circuit 20 has been set, in each frame, combined with the frequency division control signal FD (refer to the above discussed in cases 1 to 4), it is possible to control whether the first node P (for FIG. 2) or the second node Q (for FIG. 3) is electrically connected to the fourth node R, and control whether the three node S is electrically connected to the first node P (for FIG. 2) or the second node Q (for FIG. 3), so that the output gate control signal has or does not have a gate effective pulse, so as to control whether the corresponding row of the sub-pixels Pi is turned on (refreshed).

In one embodiment, as shown in FIGS. 4 and 5, the display panel is in a frequency decreasing mode or a frequency increasing mode in a time-sharing manner. The plurality of the gate driving circuits 20 include a plurality of cascaded first gate driving circuit 2001 and a plurality of cascaded second gate driving circuits 2002 after the plurality of the cascaded first gate driving circuits 2001. The plurality of sub-pixels Pi include a plurality of first sub-pixels Pi1 electrically connected to the plurality of the cascaded first gate driving circuits 2001 and a plurality of second sub-pixels Pi2 electrically connected to the plurality of the cascaded second gate driving circuits 2002. The plurality of the first sub-pixels Pi1 forms a first display area, and the plurality of the second sub-pixels Pi2 forming a second display area. In the frequency decreasing mode, a refresh rate of the first display area is greater than a refresh rate of the second display area. In the frequency increasing mode, the refresh rate of the first display area is lower than the refresh rate of the second display area.

Based on the above discussion, it can be seen that in the present disclosure, by setting the above-mentioned stage transmission frequency division control unit 203 and the output frequency division control unit 204 in the gate driving unit, it can control whether the current-stage stage transmission signal has a stage transmission effective pulse, and whether the gate control signal has a gate effective pulse.

Specifically, taking the i-th stage NScan circuit shown in FIG. 2 as an example. Based on the fact that the transistors in FIG. 2 are all P-type transistors (that is, the low voltage is the effective voltage), the third frequency division transistor T17 is in the on period (that is, the second frequency division control signal FD2 is at its lower voltage), and the first clock signal line CKL1 and the second clock signal line CKL2 transmit the first clock signal and the second clock signal respectively, it is illustrated combined with the working timing sequence of the NScan circuit shown in Figure 9. The working timing sequence may include but not limited to the following six working stages t1 to t6.

In the first stage t1, the first clock signal XCK is at low level, the second clock signal line CK is at high level, and the stage transmission signal NScan (i-1) generated by the upper-stage is at low level. The third transistor T7 is in a closed state based on the second clock signal line CK. The first transistor T4, the input transistor T3, and the tenth transistor T14 are turned on based on the first clock signal XCK. The stage transmission signal NScan (i-1) at low level is transmitted to node D, the second node Q, and the node F, so that the seventh transistor T5, thirteenth transistor T8, the second stage transmission output transistor T9, the sixth transistor T2, and the eleventh transistor T16 are turned on based on the NScan (i-1), and the second voltage VGL is transmitted to the node C and the node B, the second clock signal line CK at high level is transmitted to the node E, and the first voltage VGH is transmitted to the node P (the fourth node R), so that the second transistor T6 and the fifth transistor T1 may be turned on based on the second voltage VGL. The second clock signal line CK at high level is transmitted to the node A to charge the second capacitor C2 to equal to a voltage difference between the node A and the node B. The first voltage VGH is transmitted to the node E (the voltage of the node E may range between the first voltage VGH and the high voltage of the second clock signal line CK) to charge the first capacitor C1 to equal to a voltage difference between the node E and the node F, so that the first capacitor C1 may be charged to increase the voltage of the node F by coupling. Due to the first stage transmission output transistor T10 being turned off and the second stage transmission output transistor T9 being turned on, the generated gate control signal NScano (i) is of low voltage.

In the second stage t2, the first clock signal XCK is at high level, the second clock signal line CK is at high level, and the stage transmission signal NScan (i-1) generated by the upper-stage is at low level. The first transistor T4, the input transistor T3, and the tenth transistor T14 are in a closed state based on the first clock signal XCK. The gate of the seventh transistor T5, the node D, the second node Q, and the node F are maintained at the previous voltage. The sixth transistor T2 remains turned on. The second clock signal line CK at low level is transmitted to the node E. The voltage of node F is further pulled down by the first capacitor C1 coupled with the decrease level of the second clock signal CK, so that the eleventh transistor T16 remains turned on. The voltage of node F is transmitted to the node D, but the voltage of the node D is also increased by the coupling effect of the rise of the first clock signal XCK transmitted by the first clock signal line CKL1 in the circuit layout. The eleventh transistor T16 is turned off, the voltage of the second node Q may avoid changing with the voltage change of the node D due to the ninth transistor T12, and the second stage output transmission transistor T9 remains turned on. The seventh transistor T5 remains turned on, the first clock signal XCK at high level is transmitted to the node C and the node B, and the fifth transistor T1 and the second transistor T6 are turned off. The thirteenth transistor T8 is turned on based on the voltage of the node D. The first voltage VGH is transmitted to the first node P (the fourth node R) to turn off the first stage transmission output transistor T10. At the same time, the second clock signal line CK at low level causes the third transistor T7 to turn on. The first voltage VGH is further transmitted to the node A to charge the second capacitor C2 to equal to a voltage difference between the node A and the node B. Due to the first stage output transistor T10 being turned off and the second stage output transistor T9 being turned on, the gate control signal NScano (i) generated is of low voltage.

In the third stage t3, the first clock signal XCK is at low level, the second clock signal line CK is at high level, and the stage transmission signal NScan (i-1) generated by the upper-stage is at high level. The third transistor T7 is in a closed state based on the second clock signal line CK. The first transistor T4, the input transistor T3, and the tenth transistor T14 are turned on based on the first clock signal XCK. The stage transmission signal NScan (i-1) at high level is transmitted to the node D, the node Q, the node F, and the gate of the seventh transistor T5. The second voltage VGL is transmitted to the nodes C and B. The second stage transmission output transistor T9 is turned off, and the seventh transistor T5 is turned off based on the stage transmission signal NScan (i-1) at high level. The fifth transistor T1 and the second transistor T6 are turned on based on the second voltage VGL. The first voltage VGH is transmitted to the node E to charge the first capacitor C1 to equal to a voltage difference between the node E and the node F. The second clock signal line CK at high level is transmitted to the node A to charge the second capacitor C2 to equal to a voltage difference between the node A and the node B. The thirteenth transistor T8 is turned off based on the stage transmission signal NScan (i-1) at high level. The first node P (the fourth node R) maintains the previous (high) voltage via the third capacitor C3, causing the first stage transmission output transistor T10 to be turned off. Due to the first stage transmission output transistor T10 being turned off and the second stage transmission output transistor T9 being turned off, that is, the stage transmission output terminal OUT is floating, the generated gate control signal NScano (i) is maintained at a low voltage.

In the fourth stage t4, the first clock signal XCK is at high level, the second clock signal line CK is at low level, and the stage transmission signal NScan (i-1) generated by the upper-stage is at high level. The input transistor T3, the first transistor T4, and the tenth transistor T14 are in a closed state based on the first clock signal XCK. The gate of the seventh transistor T5, the node D, the second node Q, and the node C maintain the previous voltage. The seventh transistor T5 is turned off based on the previous high voltage. The second stage output transistor T9 is turned off based on the previous high voltage of the second node Q. The thirteenth transistor T8 is turned off based on the high voltage of the node D. The fifth transistor T1 and the second transistor T6 are turned on based on the previous low voltage of the node C. The sixth transistor T2 is turned off based on the previous high voltage of the node F. The first voltage VGH is transmitted to the node E via the fifth transistor T1, that is, the voltage of the node E remains basically unchanged. Combined with the coupling effect of the first capacitor C1, the voltage of the node F may also remain basically unchanged. The second clock signal CK at low level is transmitted to the node A via the second transistor T6. Combined with the coupling effect of the second capacitor C2, the voltage of the node B is also reduced. The third transistor T7 is turned on based on the second clock signal CK. The low voltage at point A is transmitted to the node P (the fourth node R) via the third transistor T7, thereby turning on the first stage transmission output transistor T10. Since the first stage transmission output transistor T10 is turned on and the second stage transmission output transistor T9 is turned off, the generated gate control signal NScano (i) is of high voltage.

In the fifth stage t5, the first clock signal XCK is at low level, the second clock signal line CK is at low high level, and the stage transmission signal NScan (i-1) generated by the upper-stage is at low level. The third transistor T7 is in a closed state based on the second clock signal line CK. The first transistor T4, the input transistor T3, and the tenth transistor T14 are turned on based on the first clock signal XCK. The stage transmission signal NScan (i-1) at low level is transmitted to the node D, the second node Q, and the gate of the seventh transistor T5 via the input transistor T3. The second stage transmission output transistor T9 is turned on based on the low voltage of the second node Q. The sixth transistor T2 is turned on based on the voltage of the node F to transmit the second clock signal line CK at high level to the node E, to charge the first capacitor C1 to equal to a voltage difference between the node E and the node F. The seventh transistor T5 is turned on to transmit the first clock signal XCK at low level to the node C and the node B. The fifth transistor T1 is turned on based on the first clock signal XCK at low level and the second voltage VGL. The first voltage VGH is transmitted to the node E (the voltage of the node E may range between the high voltage of the first voltage VGH and the second clock signal line CK) via the fifth transistor T1. Based on the fact that the high voltage of the first voltage VGH is equal to the high voltage of the second clock signal line CK, the voltage of the node E remains almost unchanged. The eleventh transistor T16 is turned off, which may avoid the first capacitor C1 affecting the rate of voltage drop of the second node Q. The second transistor T6 is turned on based on the low voltage of node B to transmit the second clock signal line CK at high level to the node A, in order to charge the second capacitor C2 to equal to a voltage difference between the node A and the node B. The thirteenth transistor T8 is turned on based on the low voltage of the node D, so that the first voltage VGH is transmitted to the first node P (the fourth node R), thereby turning off the first stage transmission output transistor T10. Since the first stage transmission output transistor T10 is turned off and the second stage transmission output transistor T9 is turned on, the generated gate control signal NScano (i) is of low voltage.

In the sixth stage t6, the stage transmission signal NScan (i-1) generated by the upper-stage is at low level, and the first clock signal XCK and the second clock signal line CK are alternately at low level and at high level, driving the voltage of the node F to couple downwards. The voltage of the node F gradually decreases every time it couples downwards, approaching -16V. The corresponding voltage of the second node Q gradually decreases, approaching -20V. In the first few cycles after the turning on of the seventh transistor T5 in the fifth stage, the voltage of the node F is significantly coupled downwards. The voltage of the second node Q is greatly affected by the voltage of the node F. The eleventh transistor T16 in the later stage is turned off, the voltage of the second node Q tends to stabilize and is not affected by the voltage of the node F.

It should be noted that the gate driving circuit provided by the present disclosure may be but is not limited to a 16T3C architecture or a 13T3C architecture (only the former as an example in FIGS. 2 and 3). Compared with the 13T3C architecture, the above-mentioned tenth transistor T14, twelfth transistor T15, and eleventh transistor T16 are added in the 16T3C architecture. On the one hand, when the upper-stage stage transmission signal NScan(i-1) writes low voltage to the second node Q and the node F, the voltage of the second node Q may output from both the eleventh transistor T16 and the ninth transistor T12, and the second node Q is not directly connected to the first capacitor C1 (blocked by the eleventh transistor T16) to maintain the voltage. Therefore, the voltage of the second node Q may drop faster, which is conducive to turning on the second stage transmission transistor T9. On the other hand, the second node Q is not directly connected to the first capacitor C1 (blocked by the eleventh transistor T16), so fluctuations of the voltage of the node E will not drive the change of the voltage of the second node Q, the eleventh transistor T16 plays a diode like role, and the voltage of the second node Q will not be pulled up by the node F.

Based on the above discussion, it can be seen with reference to FIG. 2 and FIG. 10 that if the stage transmission signal NScan(i-1) generated by the upper-stage is always at low level (excluding effective high voltage pulses), it can be considered that the second node and the node D is always maintained at a low voltage to always turn on the second stage transmission transistor T9 and the thirteenth transistor T8, and to always turn off the first stage transmission transistor T10, so that the stage transmission signal NScan(i) output from the current-stage is always of low voltage (excluding active high voltage pulses).

Based on the above discussion, it can be seen with reference to FIG. 2 and FIG. 10 that if the third frequency division transistor T17 is in the off period (that is, the second frequency division control signal FD2 is at its higher voltage), that is, the first node P is disconnected from the fourth node R, the voltage of the first node P may only be determined by the on-state of the thirteenth transistor T8 and the coupling effect of the third capacitor C3.

Specifically, in the first stage t1, the thirteenth transistor T8 is turned on, the first voltage VGH is transmitted to the first node P, and the first stage transmission transistor T10 is turned off. In the second stage t2, the thirteenth transistor T8 is turned on, the first voltage VGH is transmitted to the first node P, and the first stage transmission transistor T10 is turned off. In the third stage t3, the thirteenth transistor T8 is turned off, the first node P is maintained at the first voltage VGH, and the first stage transmission output transistor T10 is turned off. In the fourth stage t4, the thirteenth transistor T8 is turned off, the first node P is maintained at the first voltage VGH, and the first stage transmission output transistor T10 is turned off. In the fifth stage t5, the thirteenth transistor T8 is turned on, the first voltage VGH is transmitted to the first node P, and the first stage transmission transistor T10 is turned off. In the sixth stage t6, the thirteenth transistor T8 is turned on, the first voltage VGH is transmitted to the first node P, and the first stage transmission transistor T10 is turned off. Transistor T10 is turned off. Therefore, it can be considered that the first stage transmission transistor T10 is turned off at each stage, and the gate control signal is related to the on-state of the second stage transmission transistor T9, as follows.

In the first stage t1, the second stage transmission transistor T9 is turned on, so the stage transmission signal NScan(i) generated by the current-stage is of low voltage.

In the second stage t2, the second stage transmission transistor T9 is turned on, so the stage transmission signal NScan(i) generated by the current-stage is of low voltage.

In the third stage t3, the second stage transmission transistor T9 is turned off, that is, the stage transmission output terminal OUT is floating, so the stage transmission signal NScano(i) generated by the current-stage is maintained at a low voltage.

In the fourth stage t4, the second stage transmission transistor T9 is turned off, that is, the stage transmission output terminal OUT is floating, so the stage transmission signal NScano(i) generated by the current-stage is maintained at a low voltage.

In the fifth stage t5, the second stage transmission transistor T9 is turned on, so the stage transmission signal NScano(i) generated by the current-stage is low of voltage.

In the sixth stage t6, the second stage transmission transistor T9 is turned on, so the stage transmission signal NScano(i) generated by the current-stage is of low voltage.

In summary, if the third frequency division transistor T17 is in the off period (that is, the second frequency division control signal FD2 is at its higher voltage), the stage transmission signal NScan(i) generated by the current-stage is all of low voltage. If the third frequency division transistor T17 is in the on period (that is, the second frequency division control signal FD2 is at its lower voltage), and under the alternating action of the high and low voltages of the stage transmission signal NScan(i-1) generated by the upper-stage, the first clock signal XCK and the second clock signal CK, the stage transmission signal NScan(i) generated by the current-stage may form a stage transmission effective pulse (such as a high voltage pulse) in the corresponding time period (for example, from the starting point of the fourth stage t4 to the end point of the fifth stage in FIG. 10), thereby acting on the corresponding transistor (such as the compensation transistor M3 in FIGS. 6 and 7 ) of the corresponding row of the pixel driving circuits 302 to turn on (refresh) the corresponding row of the light emitting devices 301.

It can be understood that in the present disclosure, the stage transmission signal generated by the current-stage gate driving circuit 20 is only cascaded to the lower-stage gate driving circuit 20, and the generated gate control signal is only loaded to the corresponding row of the sub-pixels Pi. Combined with the above analysis, it can be seen that in a frame, if the first node P (for FIG. 2) or the second node Q (for FIG. 3) of the current-stage gate driving circuit 20 is not electrically connected to the fourth node R, regardless of whether the third node S is electrically connected to the first node P or the second node Q, the current-stage gate control signal does not have an effective pulse, which causes the corresponding row of the sub-pixels Pi cannot be turned on. At the same time, the current-stage stage transmission signal does not have a stage transmission effective pulse, so it cannot control the lower-stage gate driving circuit 20 to work. As a result, the lower-stage stage transmission signal and the lower-stage gate control signal do not have the stage transmission effective pulse and the gate effective pulse (that is, the row of the sub-pixels Pi corresponding to lower-stage cannot be turned on) respectively. By analogy, the subsequent rows of the sub-pixels Pi cannot be turned on. That is, only when the first the node P (for FIG. 2) or the second node Q (for FIG. 3) in each stage of the gate driving circuit 20 is electrically connected to the fourth node R, it is possible to further control whether the third node S is electrically connected to the first node P or the second node Q, to control whether each row of the sub-pixels Pi is turned on.

It should be understood that compared with the plurality of the second sub-pixel Pi, if the plurality of the first sub-pixels Pi have more frames turned on in consecutive frames, it indicates that the first display area has a higher refresh rate compared to the second display area, and vice versa.

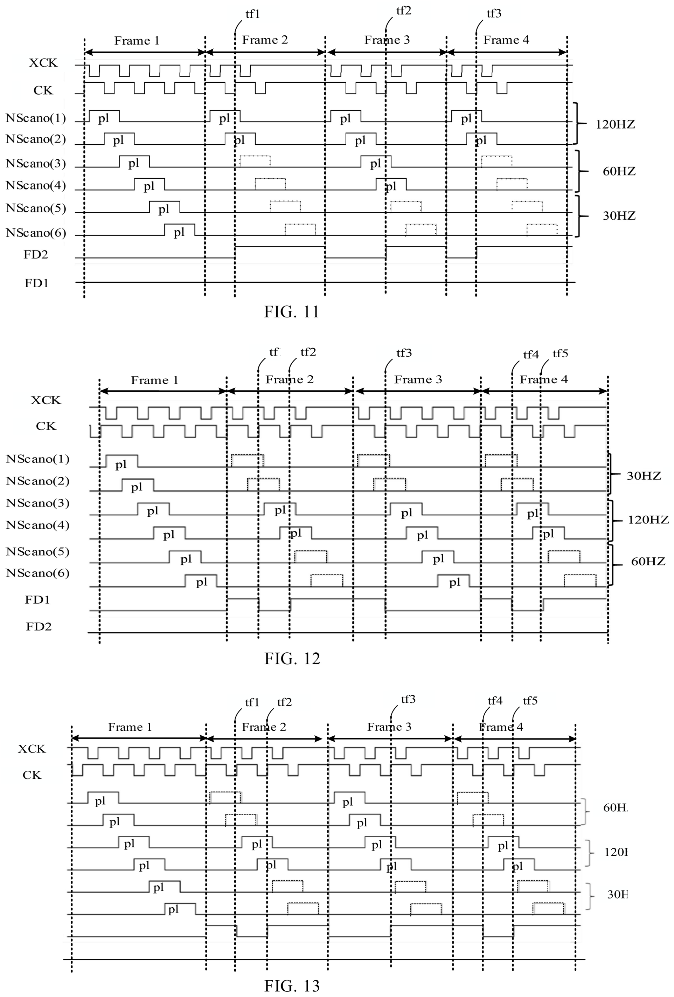

To realize the frequency decreasing mode (the refresh rate from the first display area to the second display area decreases), the following methods may be used. In at least front one (such as the Frame 1 in FIG. 11) of consecutive multiple frames, the stage transmission signals and gate control signals generated by all stages (for example, NScano(1) to NScano(6) in FIG. 11) may be controlled to have stage transmission effective pulses and gate effective pulses pl respectively. In at least one subsequent frame (such as the Frame 4 in FIG. 11), the stage transmission signals and gate control signals (for example, NScano(1) in FIG. 11 to NScano(2)) may be controlled to have stage transmission effective pulses and gate effective pulses pl respectively. The stage transmission signal generated by each second gate driving circuit 2002 may also be controlled to not have stage transmission effective pulses, so that the corresponding gate control signals (for example, NScano(3) to NScano(6) in FIG. 11) also does not have gate effective pulses, or only the generated gate control signal (such as NScano(3) to NScano(6) in FIG. 11) does not have gate effective pulses.

Specifically, combined with FIGS. 2 and 3 and related discussions, it can be seen that in the frequency decreasing mode, taking the first frequency division transistor T18 as a P-type transistor as an example, there are two implementation methods.

Method 1, referring to but not limited to FIG. 11, the first frequency division control signal FD1 (that is, its voltage is equal to the low voltage) is configured to control the third node S of each stage of the gate driving circuit 20 is electrically connected to the first node P (for FIG. 2) or the second node Q (for FIG. 3). Within one frame, the second frequency division control signal FD2 is configured to control the first node P or the second node Q of the first gate driving circuit 2001 to be electrically connected to the fourth node R, to control the output gate control signal to have a gate effective pulse pl to turn on the corresponding light-emitting device 301. Within the frame, the second frequency division control signal FD2 is configured to control the first node P or the second node Q of the second gate driving circuit 2002 to be disconnected from the fourth node R, to control that the output gate control signal to not have the gate effective pulse pl, so that the corresponding light-emitting device 301 is not turned on.

Method 2, different from method 1, the second frequency division control signal FD2 (that is, its voltage is equal to the low voltage) is configured to control the fourth node R of each stage of the gate driving circuit 20 is electrically connected to the first node P (for FIG. 2) or the second node Q (for FIG. 3). Within one frame, the first frequency division control signal FD1 is configured to control the third node S of the first gate driving circuit 2001 to be electrically connected to the first node P or the second node Q, to control the output gate control signal to have a gate effective pulse pl to turn on the corresponding light-emitting device 301. Within the frame, the first frequency division control signal FD1 is configured to control the third node S of the second gate driving circuit 2002 to be disconnected from the first node P or the second node Q, to control that the output gate control signal to not have the gate effective pulse pl, so that the corresponding light-emitting device 301 is not turned on.

Regardless of method 1 or method 2, for the first-stage gate driving circuit 20 to the sixth-stage gate driving circuit 20, it is assumed that the refresh rates of the first two stages (the 1st to the 2nd stages) of the gate driving circuits 20, the middle two stages (the 3rd to the 4th stages) of the gate driving circuit 20 and the last two stages (the 5th to the 6th stages) of the gate driving circuit 20 are 120HZ, 60HZ, and 30HZ respectively. Based on the above, it can be seen that within four consecutive frames (the Frame 1 to the Frame 4), it can be provided as follows: NScano(1) and NScano(2) have gate effective pulses pl in the Frame 1 to the Frame 4, the gate control signals NScano(3) and NScano(4) have gate effective pulses pl in the Frame 1 and the Frame 3, and the gate control signals NScano(5) and NScano(6) have gate effective pulses pl only in the Frame 1.

That is to say, the frequency division control signal FD needs to be set as follows (the following takes method 1 as an example).

The first frequency division control signal FD1 is of low voltage in the Frame 1 to the Frame 4, so that the six first frequency division transistors T18 corresponding to the first to sixth stages gate driving circuits 20 are turned on, so that the gate control signal generated by each one may be the same as the corresponding stage transmission signal.

The second frequency division control signal FD2 in the Frame 1 corresponds to a low voltage for each stage so that the six third frequency division transistors T17 corresponding to the first to sixth stages gate driving circuit 20 are turned on, so that the six stage transmission signals NScan(1) to NScan(6) and the six gate control signals NScano(1) to NScano(6) all have gate effective pulses pl in the Frame 1.

The second frequency division control signal FD2 is of low voltage before tf1 in the Frame 2, so that the two third frequency division transistors T17 corresponding to the first to second stages gate driving circuit 20 may be turned on, and NScano(1) to NScano(2) all have gate effective pulses pl in the Frame 2. The second frequency division control signal FD2 is of high voltage after tf1 in the Frame 2, so that the four third frequency divisions transistor T17 corresponding to the third to sixth stages gate driving circuits 20 may be turned off, so that NScano(3) to NScano(6) have no gate effective pulse pl in the Frame 2.

The second frequency division control signal FD2 is of low voltage before tf2 in the Frame 3, so that the four third frequency division transistors T17 corresponding to the first to fourth stages gate driving circuits 20 may be turned on, so that NScan(1) to NScan(4) all have gate effective pulses pl in the Frame 3, The second frequency division control signal FD2 are of high voltages after tf2 in the Frame 3, so taht the two third frequency divisions transistor T17 corresponding to the 5th to 6th stages gate driving circuit 20 may be turned off, so that NScan(5) to NScan(6) have no gate effective pulse pl in the Frame 3.

The analysis of the second frequency division control signal FD2 in the Frame 4 may refer to the analysis in the Frame 2.

Of course, as analyzed above and compared to FIG. 11, the second frequency division control signal FD2 may also be of low voltage in the Frame 1 to Frame 4, so that the six third frequency division transistors T17 corresponding to the first to sixth stages gate driving circuit 20 may be turned on, so that the stage transmission signal generated by each one has a stage transmission effective pulse respectively.

Further, by controlling the first frequency division control signal FD1 in each frame to have or not have a gate effective pulse during the period when the first frequency division control signal FD1 effectively acts on the gate driving circuit of the corresponding stage, the corresponding frequency division may be achieved.

In summary, the display panel may be divided into at least a first area, a second area and a third area. The first area (correspondingly acted upon by the first to second stages gate driving circuits 20) is loaded with the effective pulses pl for data writing (that is, four data refreshes is performed) in the Frame 1 to Frame 4. The second area (correspondingly acted upon by the third to fourth stages gate driving circuits 20) is loaded with the gate effective pulse pl for data writing (that is, two data refreshes is performed) in the Frame 1 and Frame 3. That is, the refresh rate of the second area is half that of the first area. Similarly, the second area (correspondingly acted upon by the 5th to 6th stages gate driving circuits 20) is loaded with the effective pulse pl for data writing (that is, one data refresh is performed) only in the Frame 1, and the refresh rate of the third area is 1/4 that of the first area. In the above example, the refresh rates of the first area, the second area and the third area may be A, (1/2)*A, (1/4)*A respectively, and A is an integer multiple of 4, then it needs to be divided into 4 frames, such as 120HZ, 60HZ, and 30HZ respectively.

For the convenience of explanation here, taking the display panel only divided into three areas as an example to illustrate, each area is correspondingly acted upon by two stages of the gate control signals, and the refresh rates of the three areas may be A, (1/2)*A, (1/4)*A respectively. Those skilled in the art should understand that the number of area divisions of the display panel and the number of rows of sub-pixels Pi contained in each area may be changed, and the corresponding refresh rate may also be adjusted. The only difference shown here is the degree of refresh rate difference in multiple areas, and frame number setting requirements. If the refresh rate of the latter is 1/3 that of the refresh rate of the former among the three areas, it needs to show 9 frames, satisfying a relationship where the refresh times for the three areas are three times. That is, the three areas are refreshed 9 times, 3 times and 1 time respectively in the 9 frames.

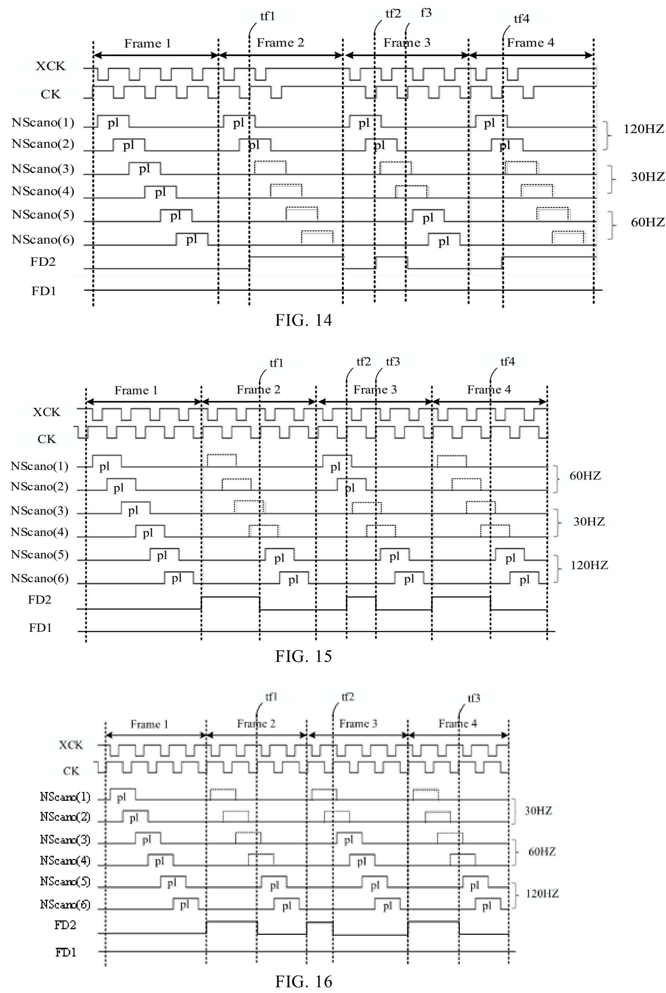

Specifically, to realize the frequency decreasing mode (the refresh rate from the first display area to the second display area increases), the following methods may be used. In at least front one (such as the Frame 1 in FIGS. 12 to 16) of consecutive multiple frames, the stage transmission signals generated by all stages may be controlled to have stage transmission effective pulses, and the gate control signals by all stages may be controlled to have gate effective pulses. In at least one subsequent frame (such as the Frame 4 in FIGS. 12 to 13, the Frame 3 in FIGS. 14 to 15, and the Frame 4 in FIG. 16), the stage transmission signal generated by each first gate driving circuit 2001 may be controlled to have stage transmission effective pulses (stage transmission continuously acting on the second gate driving circuit 2002), and the generated gate control signal does not have a gate effective pulse (such as NScan(1) to NScan(2) in FIGS. 12 to 13, NScan(3) to NScan(4) in FIGS. 14 to 15, NScan(1) to NScan(4) in FIG. 16). The stage transmission signal and the gate control signal generated by each second gate driving circuit 2002 have a stage transmission effective pulse and a gate effective pulse (such as NScan(3) to NScan(4) in FIG. 12 to FIG. 13, NScan(5) to NScan(6) in FIG. 14 to FIG. 15, NScan(5) to NScan(6) in FIG. 16) respectively.

Specifically, based on the combination of FIG. 2 and FIG. 3 and related discussions, it can be seen that in the frequency increasing mode, please refer to but not limited to FIG. 12 to FIG. 16. Taking the third frequency division transistor T17 being a P-type transistor as an example, that is, the second frequency division control signal FD2 (such as its voltage is equal to a low voltage) is configured to control the fourth node R in each stage of the gate driving circuit 20 to be electrically connected to the first node P (for FIG. 2) or the second node Q (for FIG. 3). Within one frame, the first frequency division control signal FD1 is configured to control the third node S of the first gate driving circuit 2001 to be disconnected from the first node P (for FIG. 2) or the second node Q (for FIG. 3), so that the output gate control signal does not have the gate effective pulse, and the corresponding light-emitting device 301 is not turned on. Within the frame, the first frequency division control signal FD1 is configured to control the first node P (for FIG. 2) or the second node Q (for FIG. 3) of the second gate driving circuit 2002 to be electrically connected to the fourth node R to control the output gate control signal to have the gate effective pulse to turn on the corresponding light-emitting device 301.

For example, as shown in FIG. 12, the refresh rates of the above-mentioned first two stages of gate driving circuit 20, the middle two stages of gate driving circuit 20, and the last two stages of gate driving circuit 20 are 30HZ, 120HZ, and 60HZ respectively. Based on the above, it can be seen that within the Frame 1 to the Frame 4, it can be provided as follows. NScano(1) to NScano(2) have gate effective pulses pl in the Frame 1, NScano(3) to NScano(4) have gate effective pulses pl in the Frame 1 to the Frame 4. and the gate control signals NScano(5) to NScano(6) have gate effective pulses pl in the Frame 1 and the Frame 3.

That is to say, the frequency division control signal FD needs to be set as follows.

The second frequency division control signal FD2 is of low voltage in the Frame 1 to the Frame 4, so that the six third frequency division transistors T17 corresponding to the first to sixth stages gate driving circuits 20 are all turned on, so that the stage transmission signal generated by each one has stage transmission effective pulses.

The first frequency division control signal FD1 in the Frame 1 corresponds to a low voltage for each stage, so that the six first frequency division transistors T18 corresponding to the first to sixth stages gate driving circuits 20 are turned on. The third node S may be electrically connected to the first node P or the second node Q, so that the six gate control signals NScano(1) to NScano(6) also have gate effective pulses pl in the Frame 1.

The first frequency division control signal FD1 is of high voltage before tf1 and after ft2 in the Frame 2, so that the two first frequency division transistors T18 corresponding to the gate driving circuits 20 of the 1st, 2nd, 5th, and 6th stages are turned off, so that NScano(1) to NScano(2), NScano(5) to NScano(6) do not have gate effective pulse pl in the Frame 2. The first frequency division control signal FD1 is of low voltage between tf1 to ft2 in the Frame 2, so that the two first frequency division transistors T18 corresponding to the gate driving circuit 20 of the 1st and the 3rd stages are turned on, so that NScano(1) to NScano(3) have no gate effective pulse pl in the Frame 2.

The first frequency division control signal FD1 is of high voltage before tf3 in the Frame 3, so that the two first frequency division transistors T18 corresponding to the gate driving circuits 20 of the first and second stages are turned off, so that NScano (1) to NScano(2) do not have the gate effective pulse pl in the Frame 3. The first frequency division control signal FD1 is of low voltage after tf3 in the Frame 3, so that the four first frequency division transistors T18 corresponding to the gate driving circuits 20 of the 3rd to 6th stages are turned on, so that NScano(3) to NScano(6) have gate effective pulses pl in the Frame 3.

The analysis of the first frequency division control signal FD1 in the Frame 4 may refer to the analysis in the Frame 2.

Similarly, for example, as shown in FIG. 13, the refresh rates of the above-mentioned first two stages of gate driving circuits 20, the middle two stages of gate driving circuits 20, and the last two stages of gate driving circuits 20 are 60HZ, 120HZ and 30HZ respectively. Based on the above, within the Frame 1 to Frame 4, it can be provided as follows: NScano(1) to NScano(2) have gate effective pulses pl in the Frame 1 and the Frame 3, NScano(3) to NScano( 4) have gate effective pulses pl in the Frame 1 to the Frame 4, and the gate control signals NScano(5) to NScano(6) have gate effective pulses pl only in the Frame 1.

That is to say, the frequency division control signal FD needs to be set as follows.

The second frequency division control signal FD2 is set the same as that in FIG. 12, so that the stage transmission signal generated by each stage gate driving circuit 20 has a stage transmission effective pulse.

The first frequency division control signal FD1 corresponds to low voltage for each stage in the Frame 1. Similarly, the six gate control signals NScano(1)to NScano(6) also have gate effective pulses pl in the Frame 1.

The first frequency division control signal FD1 is of high voltage before tf1 and after ft2 in the Frame 2. similarly, NScano(1) to NScano(2) and NScano(5) to NScano(6) does not have the gate effective pulse pl in the Frame 2. But the first frequency division control signal FD1 is of low voltage between tf1 and ft2. In the same way, NScano(3) to NScano(4) all have the gate effective pulses pl in the Frame 2.

The first frequency division control signal FD1 is of low voltage before tf3 in the Frame 3. Similarly, NScano(1) to NScano(4) all have gate effective pulses pl in the Frame 3. The first frequency division control signal FD1 is of high voltage after tf3. Similarly, NScano(5) to NScano(6) have no gate effective pulses pl in the Frame 3.

The analysis of the first frequency division control signal FD1 in the Frame 4 may refer to the analysis in the Frame 2.

Similarly, for example, as shown in FIG. 14, the refresh rates of the above-mentioned first two-stage gate driving circuit 20, the middle two-stage gate driving circuit 20, and the last two-stage gate driving circuit 20 are 120HZ and 30HZ respectively. , 60HZ, based on the above content, within the Frame 1 to Frame 4, it can be set as: NScano(1) to NScano(2) has gate effective pulse pl in the Frame 1 to Frame 4, NScano(3) to NScano( 4) Only the gate effective pulse pl is in the Frame 1, and the gate control signals NScano(5) to NScano(6) have the gate effective pulse pl in the Frame 1 and Frame 3;

That is to say, the frequency division control signal FD needs to be set as follows.

The second frequency division control signal FD2 is set the same as that in FIG. 12, so that the stage transmission signal generated by each stage gate driving circuit 20 has a stage transmission effective pulse.

The first frequency division control signal FD1 corresponds to low voltage for each stage in the Frame 1. Similarly, the six gate control signals NScano(1)to NScano(6) also have gate effective pulses pl in the Frame 1.

The first frequency division control signal FD1 is of low voltage before tf1 in the Frame 2. Similarly, NScano(1) to NScano(2) all have gate effective pulses pl in the Frame 2. The first frequency division control signal FD1 is of high voltage after tf1, Similarly, NScano(3) to NScano(6) have no gate effective pulse pl in the Frame 2.

The first frequency division control signal FD1 is of low voltage before tf2 and after ft3 in the Frame 3. Similarly, NScano(1) to NScano(2) and NScano(5) to NScano(6) all have gate effective pulses pl in the Frame 3. The first frequency division control signal FD1 is of high voltage between tf2 and ft3. Similarly, NScano(3) to NScano(4) do not have gate effective pulse pl in the Frame 3.

The analysis of the first frequency division control signal FD1 in the Frame 4 may refer to the analysis in the Frame 2.

Similarly, for example, as shown in FIG. 15, the refresh rates of the above-mentioned first two stages of gate driving circuits 20, the middle two stages of gate driving circuits 20, and the last two stages of gate driving circuits 20 are 60HZ, 30HZ and 120HZ respectively. Based on the above, within the Frame 1 to the Frame 4, it can be set as follows: NScano(1) to NScano(2) have gate effective pulses pl in the Frame 1 and the Frame 3, NScano(3) to NScano( 4) have gate effective pulses pl only in the Frame 1, and the gate control signals NScano(5) to NScano(6) all have gate effective pulses pl in the Frame 1 to the Frame 4;

That is to say, the frequency division control signal FD needs to be set as follows.

The second frequency division control signal FD2 is set the same as that in FIG. 12, so that the stage transmission signal generated by each stage gate driving circuit 20 has a stage transmission effective pulse.

The first frequency division control signal FD1 corresponds to low voltage for each stage in the Frame 1. Similarly, the six gate control signals NScano(1)to NScano(6) also have gate effective pulses pl in the Frame 1.

The first frequency division control signal FD1 is of high voltage before tf1 in the Frame 2. Similarly, NScano(1) to NScano(4) do not have gate effective pulse pl in the Frame 2. The first frequency division control signal FD1 is of low voltage after tf1. In the same way, NScano(5) to NScano(6) all have gate effective pulses pl in the Frame 2.

The first frequency division control signal FD1 is of low voltage before tf2 and after ft3 in the Frame 3. Similarly, NScano(1) to NScano(2) and NScano(5) to NScano(6) all have gate effective pulses pl in the Frame 3. The first frequency division control signal FD1 is of high voltage between tf2 and ft3. Similarly, NScano(3) to NScano(4) do not have gate effective pulse pl in the Frame 3.

The analysis of the first frequency division control signal FD1 in the Frame 4 may refer to the analysis in the Frame 2.

Similarly, for example, as shown in FIG. 16, the refresh rates of the above-mentioned first two stages of gate driving circuits 20, the middle two stages of gate driving circuits 20, and the last two stages of gate driving circuits 20 are 30HZ, 60HZ and 120HZ respectively. Based on the above, within the Frame 1 to the Frame 4, it may be set as: NScano(1) to NScano(2) have gate effective pulses pl only in the Frame 1, NScano(3) to NScano(4) have gate effective pulses pl in the Frame 1 and Frame 3, and the gate control signals NScano(5) to NScano(6) all have gate effective pulses pl in the Frame 1 to Frame 4.

That is to say, the frequency division control signal FD needs to be set as follows.

The second frequency division control signal FD2 is set the same as that in FIG. 12, so that the stage transmission signal generated by each stage gate driving circuit 20 has a stage transmission effective pulse.

The first frequency division control signal FD1 corresponds to low voltage for each stage in the Frame 1. Similarly, the six gate control signals NScano(1) to NScano(6) also have gate effective pulses pl in the Frame 1.

The first frequency division control signal FD1 is of high voltage before tf1 in the Frame 2. Similarly, NScano(1) to NScano(4) do not have gate effective pulse pl in the Frame 2. The first frequency division control signal FD1 is of low voltage after tf1. Similarly, NScano(5) to NScano(6) all have gate effective pulses pl in the Frame 2.

The first frequency division control signal FD1 is of high voltage before tf2 in the Frame 3. Similarly, NScano(1) to NScano(2) do not have gate effective pulse pl in the Frame 3. The first frequency division control signal FD1 is of low voltage after tf2. Similarly, NScano(3) to NScano(6) all have gate effective pulse pl in the Frame 3.

The analysis of the first frequency division control signal FD1 in the Frame 4 may refer to the analysis in the Frame 2.

Combined with the relevant discussions of FIGS. 11 to 16, the display panel may be further divided into m areas corresponding to m gate driving circuits 20 cascaded in sequence, and the corresponding m refresh rates may be expressed as a/(j1), a/(j2) to a/(jm), where j1 to jm are all positive integers. The m refresh rates are all positive integers. The number of frames should be set to the least common multiples of the m numbers from j1 to jm, such as, including the two refresh rates of 120Hz and 1Hz, there should be 120 frames as one cycle. For the same reason, please refer to the relevant description above about "m is the least common multiple of n1, n1, and n1".

In summary, the first frequency division control signal FDI and the second frequency division control signal FD2 may be reasonably controlled based on the refresh rate relationship between the first area, the second area A2 and the third area. For example, the first area A1, the second area A2 and the third area A3 are respectively used for video playback, comment area screen (may be scrolled based on needs), and keyboard screen, that is, the refresh rate of the three is reduced in sequence. At this time, the above-mentioned the first frequency division control signal FD1 may be set to continue to maintain a low voltage in multiple frames, achieving the jump from effective (low) voltage to ineffective (high) voltage relying on the second frequency division control signal FD2. The above-mentioned second frequency division control signal FD2 may also be set to continue to maintain a low voltage in multiple frames, achieving the jump from an effective (low) voltage to an ineffective (high) voltage relying on the first frequency division control signal FD1. For example, the first area A1, the second area A2 and the third area A3 are respectively used for date display, video playback, and comment area screen (may be scrolled based on demand), that is, the refresh rate of the three shows a trend of rising first and then falling. At this time, by setting the above-mentioned second frequency division control signal FD2 to continue to maintain a low voltage in multiple frames, each stage may output stage transmission effective pulses, and relying on the first frequency division control signal FD1 to achieve the jump from ineffective (high) voltage to effective (low) voltage, and then from effective (low) voltage to ineffective (high) voltage.

The frame in which the gate of the multi-stage gate control signals corresponding to any area has a gate effect pulse may be called the writing frame of the area, which is configured to turn on the sub-pixel Pi. So that the corresponding at least one data string may be respectively loaded onto the corresponding at least one row of sub-pixels Pi. The frame without the gate effect pulse is called the holding frame of the area, so that the corresponding at least one row of sub-pixels Pi are respectively maintained as at least one corresponding data string. For example, the Frame 1 in FIGS. 11 to 16 is the writing frame for the three areas corresponding to the first 2 stages, the middle 2 stages, and the last 2 stages of the gate driving circuits 20 at the same time. The Frame 2 and the Frame 4 in FIGS. 12 to 13 is simultaneously the writing frame of an area corresponding to the middle two stages of gate driving circuits 20, and is also the holding frame of an area corresponding to the first two stages and last two stages of gate driving circuits 20. The Frame 3 in FIGS. 14 to 15 is simultaneously the holding frame of an area corresponding to the middle two stages of gate driving circuits 20, and is also the writing frame of an area corresponding to the first two stages and last two stages of gate driving circuits 20. The Frame 2 and the Frame 4 in FIGS. 15 and 16 are simultaneously the holding frames of an area corresponding to the first two stages and the middle two stages of gate driving circuits 20, and are also the writing frames of an area corresponding to the last two stages of gate driving circuits 20.

Continued from the preceding discussion, it can be considered that in the writing frame, the gate effective pulse in the gate control signal turns on the corresponding row of sub-pixels Pi, so that multiple sub-data in the corresponding data string are transmitted to the corresponding multiple sub-pixels Pi. Therefore, it can be determined based on whether the two data strings corresponding to the two adjacent rows of sub-pixels Pi change (that is, whether the two voltage values corresponding to the two adjacent sub-data transmitted by the data line electrically connected to any column of sub-pixels Pi are the same, that is, whether the data signal transmitted by the data line jumps), to determine whether the frame is a writing frame for the lower-row of sub-pixels Pi, or a holding frame for the upper-row of sub-pixels Pi.

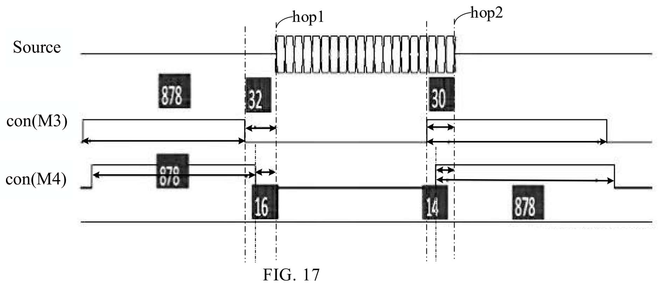

As shown in FIG. 17, if the data signal SOURCE transmitted by the data line jumps, due to progressive scanning, that is, the data signal transmitted by each data line will also have an effective jump hop1 (that is, the corresponding stage of the gate control signal needs to have a gate effective pulse to turn on the sub-pixel Pi of the corresponding row to load multiple sub-data after the jumping), the frequency division control signal FD may be set to control the corresponding gate effective pulse to be generated before the corresponding data string appears, to ensure that the sub-pixel Pi of the corresponding row is turned on. Based on the fact that the first frequency division transistor T18 and the second frequency division transistor T20 are both P-type transistors, that is, the first frequency division control signal FD1 and the first frequency division control signal FD1 are both set to be of low voltage to turn on the above two.

Specifically, taking FIG. 6 as an example, the NScano2 signal and NScano1 signal in FIG. 8 respectively represent the signals loaded on the gates of M3 and M4 (both P-type transistors) in FIG. 6. The con(M3) signal and con(M4) signal in FIG. 17 may respectively represent the total frequency division control signal FD in the two NScan circuits configured to generate the NScano2 signal and the NScano1 signal. The "total frequency division control signal FD" may be understood as the sum of the first frequency division control signal FD1 and the second frequency division control signal FD2 in the NScan circuit, that is, only when both are at effective (low) voltage, the "total frequency division control signal FD" is at the effective (low) voltage, otherwise it will be at the ineffective (high) voltage.

Referring to the above discussion about FIGS. 6 and 8, the NScano2 signal needs to be at an effective (high) voltage earlier than the NScano 1 signal, so that the compensation transistor M3 is turned on during the first restoration phase tim1 so that the anode of the light-emitting device 301 can be reset based on the initialized signal VI2. Then in the second restoration phase tim2, the restoration transistor M4 is turned on so that the gate of the driving transistor M1 is reset based on the initialization signal V12. Therefore, as shown in FIG. 17, for example, the con(M3) signal and the con(M4) signal corresponding to two NScan circuits jump from the ineffective (high) voltage to the effective (low) voltage 32 row cycles and 16 row cycles earlier than the "sub-data effective jump hop1" respectively, to turn on the compensation transistors and the restoration transistor in sequence. It can be seen from the relevant discussions in FIGS. 2 and 3 that the first restoration phase tim1 and the second restoration phase tim2 of the corresponding row sub-pixels Pi may be sequentially complete.

Further, still based on what is shown in FIG. 6, the frequency division control signal FD (also called the con(M2) signal) in the PScan circuit configured to generate the PScano signal may be controlled to jump from an ineffective (high) voltage to an effective (low) voltage (not shown in FIG. 17) earlier than the "sub-data effective jump hop1" (less than 16 row cycles), or equal to "sub-data effective jump hop1" to turn on the data transistor. The frequency division control signal FD is the data signal transmitted by the data line during the period from the effective transition hop1 to the ineffective transition hop2 to perform the data writing phase tim3.

Further, still based on what is shown in FIG. 6, after the "sub-data ineffective jump hop2", the frequency division control signal FD (also called con(M5/6) in the EM circuit configured to generate the EMo1 signal may be controlled to jump from an ineffective (high) voltage to an effective (low) voltage (not shown in FIG. 17) to turn on the first light-emitting control transistor and the second light-emitting control transistor. The frequency division control signal FD is the data signal transmitted by the data line during the period from the effective transition hop1 to the ineffective transition hop2 to perform the light-emitting phase tim4.

Still based on what is shown in FIG. 6, between the light-emitting stage tim4 and the data writing stage tim3, the frequency division control signal FD (also called con (M7/8) signal) may be controlled to jump from an ineffective (high) voltage to an effective (low) voltage (not shown in FIG. 17) to turn on the initial transistor and reset transistor for performing the third restoration stage tin.

The above-mentioned "row period" may be understood as the sum of the on-time duration and the row blanking time of each row of sub-pixels Pi. In FIG. 17, only in one frame, the first 878 rows of sub-pixels Pi are in the holding frame (that is, the duration of the corresponding con(M3) signal and con(M4) signal at the ineffective (high) voltage is first maintained at 878 line cycles). The con(M3) signal and con(M4) signal jump from effective (low) voltage to ineffective (high) voltage respectively ahead of the "sub-data in effective jump hop2" 30 row cycles and 14 row cycles. The subsequent 878 rows of sub-pixels Pi are also in the holding frame (that is, the duration of the corresponding con(M3) signal, con(M4) at the ineffective (high) voltage is also maintained at 878 line cycles).

In summary, in the embodiment, the waveform of the "total frequency division control signal FD" of the corresponding at least one gate driving circuit 20 may be set based on the "sub-data effective jump hop1" and "sub-data effective jump hop1" of the data signal transmitted by the data line. For example, in the low-frequency area, the source signal is a constant voltage signal in the holding frame. At this time, the "total frequency division control signal FD" may be equal to the ineffective (high) voltage, in order to not output the effective gate pulse. For example, in the high-frequency area, when the "sub-data effective jump hop1" occurs in the Source signal, the "total frequency division control signal FD" may be triggered to jump to an effective (low) voltage, allowing the effective gate pulse to be output normally. And combined with the above analysis, it can be seen that the jumping moment of the "total frequency division control signal FD" in the different gate driving circuits 20 corresponding to the different transistors of the pixel driving circuits 302 may be at, ahead of, or lagging behind the "sub-data effective transition hop1" to implement different working stages respectively.

It should be noted that, in conjunction with the above discussion about FIG. 2, FIG. 3 and FIG. 10, in any stage gate driving circuit 20, if at least one of the first clock signal and the second clock signal is equal to a constant voltage, it may causes that the corresponding stage transmission signal and gate control signal will not have stage transmission effective pulses and gate effective pulses respectively, so that the sub-pixel Pi of the corresponding row cannot be refreshed (that is, cannot be turned on).

Further, the gate driving module 10 includes n-stage gate driving circuits 20 cascade in sequence, and n is a positive integer greater than or equal to 2. The n-stage gate driving circuits 20 are all loaded with the same clock signals (for example, the 6-stage gate driving circuit 20 in FIGS. 11 to 16 are all loaded with the first clock signal and the second clock signal, and it can be considered that the positions where the first clock signal and the second clock signal are loaded in the adjacent two stages are opposite). Within one frame, the clock signal is alternately equal to the first clock voltage and the second clock voltage during the period when the clock signal effectively acts on the gate driving circuit 20 from the i-th to (i+k)-th stages. The clock signal may be the high voltage and low voltage in the first clock signal and the second clock signal respectively, that is, they can control the multi-row sub-pixel Pi corresponding to the i-th to (i+k)-th stages gate control signals to turn on, and i, k are positive integers greater than or equal to 1. When the gate control signal output from the gate driving circuit 20 from the (i+k+1)-th to the n-th stages does not include the gate effective pulse, the clock signal is equal to the first clock voltage or the second clock voltage (just meet that the corresponding multiple sub pixels Pi are not turned on) during the period when the clock signal effectively acts on the gate driving circuit 20 from the (i+k+1)-th to the n-th stages.

It can be understood that since gate control signals from the i-th to (i+k)-th stages all have gate effective pulses, and the gate control signals from the (i+k+1)-th to n-th stages all do not have gate effective pulses. Based on this, in the embodiment, the clock signal is set to be equal to a constant voltage during the period when it effectively acts on the gate driving circuits 20 from the (i+k+1)-th to n-th stages. Not only can it comply with "the gate control signals from the (i+k+1) to the n-th stages respectively do not have effective gate pulses", but it may also save power consumption.

Further, in order to ensure that the gate effective pulse of the (i+k)-th stage gate control signal is completely generated (to avoid interruption due to the clock signal becoming a constant voltage signal), the clock signal may be set to equal to the constant voltage signal after the gate effective pulse is completely generated.

It should be noted that it must be satisfied that the last several stages of gate control signals do not have gate effective pulses. If there is at least one last stage of gate control signal that has gate effective pulses, the voltages of the gate driving circuits 20 of the corresponding stages of the front several stages of the gate control signals that do not have effective gate pulses and which the clock signal effectively acts on, cannot be set to be constant voltages, because this will also cause the inability to generate stage transmission signal that acts on the lower-stage, and it is impossible to realize that at least one subsequent gate control signal has a gate effective pulse.

Specifically, for example, as shown in FIG. 11, in the Frame 2 and Frame 4, after the end time of the gate effective pulse in NScano(2), at least one of the first clock signal and the second clock signal (both can be equal or unequal) is set to be equal to at least one of the high voltage and the low voltage. In the Frame 3, after the end time of the gate effective pulse in NScano(4), at least one of the first clock signal and the second clock signal is set equal to at least one of the high voltage and the low voltage.

In the same way, for example, as shown in FIG. 12, in the Frame 2 and the Frame 4, after the end time of the gate effective pulse in NScano (4), at least one of the first clock signal and the second clock signal may be set equal to at least one of high voltage and low voltage.

In the same way, for example, as shown in FIG. 13, in the Frame 2 to Frame 4, after the end time of the gate effective pulse in NScano (4), at least one of the first clock signal and the second clock signal may be set equal to at least one of high voltage and low voltage.

In the same way, for example, as shown in FIG. 14, in the Frame 2 and Frame 4, after the end time of the gate effective pulse in NScano(2), at least one of the first clock signal and the second clock signal may be set equal to at least one of high voltage and low voltage.

As discussed above, for example, as shown in FIGS. 15 and 16, in the Frame 1 and the Frame 4, since NScano(5) and NScano(6) (corresponding to the last two stages of gate driving circuits 20) both have gates effective pulses, so in each frame, the first clock signal and the second clock signal need to be maintained and alternately set to the first clock voltage and the second clock voltage to ensure that the stage transmission signal from each stage may be generated until the sixth stage gate control signal generated.

The stage transmission frequency division control unit electrically connected to the stage transmission receiving unit through the first node or the second node (also electrically connected to the stage transmission output unit through the fourth node), an output frequency division control unit connected between the first node, one of the second nodes, and the third node, both of which are configured to control the first node based on the frequency division control signal The signal from one of the second nodes is configured to control the output unit of the stage transmission to output the stage transmission signal from the current stage, and the signal from the third node is controlled based on the frequency division control signal to control the output unit to output the gate control signal from the current stage, so that the inefficiency of the gate control signal may not affect the inefficiency of the stage transmission signal, The sequential frequency decreasing mode of multiple areas on the display panel can be achieved by setting whether the stage signal has stage effective pulses, and by setting whether the gate control signal has gate effective pulses (as stage effective pulses can always exist), any frequency conversion mode of multiple areas on the display panel can be achieved.

The principle and implementations of the present disclosure are described in this specification by using specific examples. The description about the foregoing embodiments is merely provided to help understand the method and core ideas of the present disclosure. In addition, persons of ordinary skill in the art can make modifications in terms of the specific implementations and application scopes according to the ideas of the present disclosure. Therefore, the content of this specification shall not be construed as a limit to the present disclosure.

## Claims

1. A gate driving module, comprising a frequency division signal line and a plurality of cascaded gate driving circuits, wherein the frequency division signal line is configured to transmit a frequency division control signal to the plurality of the cascaded gate driving circuits, and each of the cascaded gate driving circuits comprises:
a stage transmission unit comprising a stage transmission receiving unit and a stage transmission output unit, wherein the stage transmission receiving unit is configured to receive a stage transmission signal generated by an upper-stage gate driving circuit, the stage transmission output unit is electrically connected to the stage transmission receiving unit via a first node and a second node, and the stage transmission output unit is configured to output a current-stage stage transmission signal to a lower-stage gate driving circuit based on signals from the first node and the second node;
an output unit electrically connected to the stage transmission output unit via a third node and one of the first node and the second node, and configured to output a gate control signal based on a signal from the one of the first node and the second node, and a signal from the third node;
a stage transmission frequency division control unit electrically connected to the stage transmission receiving unit via the first node or the second node, electrically connected to the stage transmission output unit via a fourth node, and configured to control the signal from the one of the first node and the second node based on the frequency division control signal to control the stage transmission output unit to output the current-stage stage transmission signal; and
an output frequency division control unit connected between the third node and the one of the first node and the second node, and configured to control the signal from the third node based on the frequency division control signal to control the output unit to output a current-stage gate control signal.

2. The gate driving module of claim 1, wherein the frequency division control signal comprises a first frequency division control signal and a second frequency division control signal, and the frequency division signal line comprises a first frequency division signal line configured to transmit the first frequency division control signal and a second frequency division control signal configured to transmit the second frequency division control signal;
wherein the first frequency division signal line is electrically connected to the output frequency division control unit to control the signal from the third node; and
wherein the second frequency division signal line is electrically connected to the stage transmission frequency division control unit to control the signal from the one of the first node and the second node.

3. The gate driving module of claim 2, wherein the output frequency division control unit comprises:
a first frequency division transistor, wherein a gate of the first frequency division transistor is connected to the first frequency division signal line, a source of the first frequency division transistor is electrically connected to the first node or the second node, and a drain of the control transistor is electrically connected to the third node;
wherein the first frequency division control signal is configured to control the third node to be electrically connected to or disconnected from the first node or the second node.

4. The gate driving module of claim 3, wherein the output frequency division control unit further comprises:
a second frequency division transistor, wherein a gate of the second frequency division transistor is electrically connected to a fifth node of the stage transmission unit, a source of the second frequency division transistor is electrically connected to the first frequency division signal line, and a drain of the second frequency division transistor is electrically connected to the gate of the first frequency division transistor;
wherein the first frequency division control signal and a signal from the fifth node are configured to control the third node to be electrically connected to or disconnected from the first node or the second node; and
wherein the signal from the fifth node is further configured to control a stage transmission signal and the gate control signal output from a current-stage gate driving circuit.

5. The gate driving module of claim 2, wherein the stage transmission frequency division control unit comprises:
a third frequency division transistor, wherein a gate of the third frequency division transistor is electrically connected to the second frequency division signal line, a source of the first frequency division transistor is electrically connected to the stage transmission receiving unit via the fourth node, and a drain of the third frequency division transistor is electrically connected to the first node or the second node;
wherein the second frequency division control signal is configured to control the fourth node to be electrically connected to or disconnected from the first node or the second node.

6. The gate driving module of claim 3, wherein the stage transmission frequency division control unit comprises:
a third frequency division transistor, wherein a gate of the third frequency division transistor is electrically connected to the second frequency division signal line, the source of the first frequency division transistor is electrically connected to the stage transmission receiving unit via the fourth node, and a drain of the third frequency division transistor is electrically connected to the first node or the second node;
wherein the second frequency division control signal is configured to control the fourth node to be electrically connected to or disconnected from the first node or the second node.

7. The gate driving module of claim 6, wherein the stage transmission output unit comprises:
a first stage transmission output transistor, wherein a gate of the first stage transmission output transistor is electrically connected to the first node, a source of the first stage transmission output transistor is electrically connected to the first voltage line to load a first voltage, and a drain of the first stage transmission output transistor is electrically connected to a stage transmission output terminal of a current-stage gate driving circuit for outputting the stage transmission signal; and
a second stage transmission output transistor, wherein a gate of the second stage transmission output transistor is electrically connected to the second node, a source of the second stage transmission output transistor is electrically connected to the second voltage line to load a second voltage, and a drain of the second stage transmission output transistor is electrically connected to the stage transmission output terminal.

8. The gate driving module of claim 7, wherein the output unit comprises:
a first output transistor, wherein a gate of the first output transistor is electrically connected to the third node, a source of the first output transistor is electrically connected to the first voltage line, a drain of the first output transistor is electrically connected to a gate output terminal of the current-stage gate driving circuit for outputting the gate control signal; and
a second output transistor wherein a gate of the second output transistor is electrically connected to the first node or the second node, a source of the second output transistor is electrically connected to the second voltage line, and a drain of the second output transistor is electrically connected to the gate output terminal.

9. The gate driving module of claim 8, wherein each of the cascaded gate driving circuits is electrically connected to at least one corresponding pixel driving circuit, the gate output terminal is electrically connected to a transistor of each of the at least one corresponding pixel driving circuit, and the first voltage is greater than the second voltage;
wherein the pixel transistor is an N-type transistor, and the drain of the third frequency division transistor and the source of the first frequency division control transistor are both electrically connected to the first node; or
the pixel transistor is a P-type transistor, and the drain of the third frequency division transistor and the source of the first frequency division control transistor are both electrically connected to the second node.

10. The gate driving module of claim 6, wherein the stage transmission receiving unit comprises:
a fourth node control unit electrically connected to a clock signal line and the fourth node and configured to control a signal from the fourth node based on a clock signal transmitted by the clock signal line;
a second node control unit electrically connected to the clock signal line and the second node and configured to control the signal from the second node based on the clock signal; and
an input unit, wherein an input terminal of the input unit is electrically connected to the upper-stage gate driving circuit to load the stage transmission signal generated by the upper-stage gate driving circuit, and an input terminal of the input unit is electrically connected to the fourth node control unit and the second node control unit, or electrically connected to the fourth node control unit and the first node control unit.

11. The gate driving module of claim 10, wherein the stage transmission frequency division control unit and the output frequency division control unit are both electrically connected to the first node;
the input unit comprises an input transistor, a gate of the input transistor is loaded with the clock signal, a source of the input transistor is configured as the input terminal of the input unit, and a drain of the input transistor is configured as the output terminal of the input unit;
the fourth node control unit comprises a second transistor and a third transistor arranged in series, a first transistor, and a seventh transistor, a gate of the seventh transistor is electrically connected to the drain of the input transistor, a source of the seventh transistors is loaded with the clock signal, a gate of the first transistor is loaded with the clock signal, a source of the first transistor is loaded with the second voltage, a drain of the first transistor is electrically connected to a gate of the second transistor and a drain of the seventh transistor, a drain of the second transistor is electrically connected to a source of the third transistor, a source of the second transistor and a gate of the third transistor are both loaded with the clock signal, and a drain of the third transistor is electrically connected to the fourth node; and
the second node control unit comprises a fifth transistor and a sixth transistor arranged in series, a fourth transistor, and a first capacitor, a gate of the fourth transistor is loaded with a control signal, a source of the fourth transistor is loaded with the first voltage, a drain of the fourth transistor is electrically connected to the second node, a gate of the fifth transistor is electrically connected to the drain of the first transistor, a source of the fifth transistor is loaded with the first voltage, a drain of the fifth transistor is electrically connected to a source of the sixth transistor, a drain of the sixth transistor is loaded with the clock signal, a gate of the sixth transistor is loaded with the stage transmission signal generated by the upper-stage gate driving circuit, and the first capacitor is electrically connected between the gate and the drain of the sixth transistor.

12. The gate driving module of claim 11, wherein the second node control unit further comprises:
a tenth transistor, wherein a source of the tenth transistor is loaded with the stage transmission signal generated by the upper-stage gate driving circuit, a gate of the tenth transistor is loaded with the clock signal, and a drain of the tenth transistor is electrically connected to the gate of the sixth transistor; and
an eleventh transistor, wherein a gate and a source of the eleventh transistor are both electrically connected to the gate of the sixth transistor, and a drain of the eleventh transistor is electrically connected to the second node.

13. A display panel, comprising:
a gate driving module of claim 2; and
a panel body comprising a plurality of sub-pixels and a plurality of scanning lines, wherein the plurality of sub-pixels comprise a plurality of light-emitting devices and a plurality of pixel driving circuits for driving the light-emitting devices to emit light, and each of the pixel driving circuits comprises at least one transistor;
wherein gate control signals output from the cascaded gate driving circuits are transmitted to gates of a plurality of transistors of corresponding pixel driving circuits via corresponding scanning lines.

14. The display panel of claim 13, wherein the output frequency division control unit comprises:
a first frequency division transistor, wherein a gate of the first frequency division transistor is connected to the first frequency division signal line, a source of the first frequency division transistor is electrically connected to the first node or the second node, and a drain of the control transistor is electrically connected to the third node;
wherein the first frequency division control signal is configured to control the third node to be electrically connected to or disconnected from the first node or the second node.

15. The display panel of claim 13, wherein the display panel is in a frequency decreasing mode or a frequency increasing mode in a time-sharing manner, and the plurality of the cascaded gate driving circuits comprise a plurality of cascaded first gate driving circuits and a plurality of cascaded second gate driving circuits cascaded after the plurality of the cascaded first gate driving circuits; and
wherein the plurality of sub-pixels comprise a plurality of first sub-pixels electrically connected to the plurality of the cascaded first gate driving circuits and a plurality of second sub-pixels electrically connected to the plurality of the cascaded second gate driving circuits, the plurality of the first sub-pixels form a first display area, and the plurality of the second sub-pixels form a second display area;
in the frequency decreasing mode, a refresh rate of the first display area is greater than a refresh rate of the second display area; and
in the frequency increasing mode, the refresh rate of the first display area is lower than the refresh rate of the second display area.

16. The display panel of claim 15, wherein in the frequency decreasing mode, the first frequency division control signal is configured to control the third node of each stage of the cascaded gate driving circuits to be electrically connected to the first node or the second node;
in a first type of frame, the second frequency division control signal is configured to control the first node or the second node of each stage of the cascaded first gate driving circuits to be electrically connected to the fourth node, in order to control an output gate control signal to have a gate effective pulse to activate corresponding one of the light-emitting devices; and
in the first type of frame, the second frequency division control signal is further configured to control the first node or the second node of each stage of the cascaded second gate driving circuits to be disconnected from the fourth node, in order to control the output gate control signal to not have the gate effective pulse to not activate corresponding one of the light-emitting devices.

17. The display panel of claim 15, wherein in the frequency decreasing mode, the second frequency division control signal is configured to control the fourth node of each stage of the cascaded gate driving circuits to be electrically connected to the first node or the second node;
in a second type of frame, the first frequency division control signal is configured to control the third node of each stage of the cascaded first gate driving circuits to be electrically connected to the first node or the second node, in order to control an output gate control signal to have a gate effective pulse to activate corresponding one of the light-emitting devices; and
in the second type of frame, the first frequency division control signal is further configured to control the third node of each stage of the cascaded second gate driving circuits to be disconnected from the first node or the second node, in order to control the output gate control signal to not have the gate effective pulse to not activate corresponding one of the light-emitting devices.

18. The display panel of claim 15, wherein in the frequency increasing mode, the second frequency division control signal is configured to control the fourth node of each stage of the cascaded gate driving circuits to be electrically connected to the first node or the second node;
in a third type of frame, the first frequency division control signal is configured to control the third node of each stage of the cascaded first gate driving circuits to be disconnected from the first node or the second node, in order to control an output gate control signal to not have a gate effective pulse to not activate corresponding one of the light-emitting devices; and
in the third type of frame, the first frequency division control signal is further configured to control the first node or the second node of each stage of the cascaded second gate driving circuits to be electrically connected to the fourth node, in order to control the output gate control signal to have the gate effective pulse to activate corresponding one of the light-emitting devices.

19. The display panel of claim 16, wherein in the frequency increasing mode, the second frequency division control signal is configured to control the fourth node of each stage of the cascaded gate driving circuits to be electrically connected to the first node or the second node;
in a third type of frame, the first frequency division control signal is configured to control the third node of each stage of the cascaded first gate driving circuits to be disconnected from the first node or the second node, in order to control the output gate control signal to not have a gate effective pulse to not activate corresponding one of the light-emitting devices; and
in the third type of frame, the first frequency division control signal is further configured to control the first node or the second node of each stage of the cascaded second gate driving circuits to be electrically connected to the fourth node, in order to control the output gate control signal to have the gate effective pulse to activate corresponding one of the light-emitting devices.

20. The display panel of claim 13, wherein the gate driving module comprises sequentially cascaded n-stage of the cascaded gate driving circuits, n is a positive integer greater than or equal to 2, and the n-stage of the cascaded gate driving circuits are loaded with a same clock signal;
in one frame, the clock signal is alternately equal to a first clock voltage or a second clock voltage during a period of effective action on i-th stage to (i+k)-th stage of the cascaded gate driving circuits, and i and k are positive integers greater than or equal to 1;
wherein when gate control signals output from (i+k+1)-th stage to n-th stage of the cascaded gate driving circuits do not comprise gate effective pulses, the clock signal is identically equal to the first clock voltage or the second clock voltage during a period of effective action on (i+k+1)-th stage to n-th stage of the cascaded gate driving circuits.
